# EUROPEAN PATENT APPLICATION

(11) **EP 4 436 341 A2**
(43) Date of publication of application: **25.09.2024**
(21) Application number: 24165333.6
(22) Date of filing: 21.03.2024
(51) Int. Cl.: H10K 59/122, H10K 59/80

(54) **DISPLAY APPARATUS AND METHOD OF MANUFACTURING THE SAME**

(30) Priority: 24.03.2023 KR 20230039177; 19.05.2023 KR 20230065228
(71) Applicant: Samsung Display Co., Ltd., Yongin-si, Gyeonggi-do 17113 (KR)
(72) Inventor: SONG, Eunho, 17113 Yongin-si (KR); KIM, Gunhee, 17113 Yongin-si (KR); SONG, Daeho, 17113 Yongin-si (KR); LEE, Sunhee, 17113 Yongin-si (KR); JUNG, Sunyoung, 17113 Yongin-si (KR)
(74) Representative: Marks & Clerk LLP

(57) **Abstract**

A display apparatus includes a first pixel (Pr) disposed on a substrate (100) and including a first pixel electrode (211), a first emission layer (241) disposed on the first pixel electrode (211), and a first opposite electrode (261) disposed on the first emission layer (241), a second pixel (Pg) disposed on the substrate (100) and including a second pixel electrode (213), a second emission layer (243) disposed on the second pixel electrode (213), and a second opposite electrode (263) disposed on the second emission layer (243), a pixel defining layer (120) disposed on the first pixel electrode (211) and the second pixel electrode (213) and including an opening (OP1), the opening exposing each of at least a portion of the first pixel electrode (211) and at least a portion of the second pixel electrode (213), a trench (Tr) formed in the pixel defining layer (120), and a connection electrode (400) electrically connecting the first opposite electrode (261) to the second opposite electrode (263).

## Description

### BACKGROUND

### 1. Technical Field

One or more embodiments relate to a display apparatus and a method of manufacturing the same.

### 2. Description of the Related Art

A display apparatus visually displays data. The display apparatus may provide an image by using light-emitting diodes. Recently, the display apparatuses have been diversified in use. Accordingly, various designs of display apparatuses have been attempted to improve the quality of the display apparatuses.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

One or more embodiments include a display apparatus and a method of manufacturing the same.

Additional aspects will be set forth in part in the description which follows and, in part, will be apparent from the description, or may be learned by practice of the disclosure.

According to one or more embodiments, a display apparatus includes a first pixel disposed on a substrate and including a first pixel electrode; a first emission layer disposed on the first pixel electrode; and a first opposite electrode disposed on the first emission layer; a second pixel disposed on the substrate and including a second pixel electrode; a second emission layer disposed on the second pixel electrode; and a second opposite electrode disposed on the second emission layer; a pixel defining layer disposed on the first pixel electrode and the second pixel electrode and including an opening, the opening exposing each of at least a portion of the first pixel electrode and at least a portion of the second pixel electrode a trench formed in the pixel defining layer and a connection electrode electrically connecting the first opposite electrode to the second opposite electrode.

In an embodiment, a width of the trench may be about 5 nm or more and about 200 nm or less.

In an embodiment, the first emission layer and the second emission layer may be disconnected from each other by the trench.

In an embodiment, the first opposite electrode and the second opposite electrode may be disconnected from each other by the trench.

In an embodiment, the trench may include a plurality of trenches.

In an embodiment, the display apparatus may further include an insulating layer disposed between the substrate and the pixel defining layer, wherein the trench may be formed in at least a portion of the insulating layer.

In an embodiment, the display apparatus may further include a dummy emission layer and a dummy opposite electrode inside of the trench.

In an embodiment, the dummy emission layer and the first emission layer may include a same material.

In an embodiment, the dummy opposite electrode and the first opposite electrode may include a same material.

In an embodiment, the first emission layer and the second emission layer may emit light of a same color.

In an embodiment, the first emission layer and the second emission layer may emit light of different colors.

In an embodiment, the display apparatus may further include an inorganic encapsulation layer disposed on the first opposite electrode and the second opposite electrode, wherein a second opening exposing at least a portion of each of the first opposite electrode and the second opposite electrode may be defined in the inorganic encapsulation layer.

In an embodiment, the connection electrode may be provided in the second opening of the inorganic encapsulation layer.

In an embodiment, the display apparatus may further include a first color filter and a second color filter, wherein the first color filter and the second color filter may be disposed on the inorganic encapsulation layer.

In an embodiment, the first color filter may at least partially overlap the first emission layer, and the second color filter may at least partially overlap the second emission layer.

In an embodiment, light of a first color may pass through the first color filter, and light of a second color different from the light of the first color may pass through the second color filter.

According to one or more embodiments, a method of manufacturing a display apparatus includes forming a first pixel electrode and a second pixel electrode on a substrate; forming a pixel defining layer including a trench on the first pixel electrode and the second pixel electrode; and forming the first emission layer and the second emission layer respectively on the first pixel electrode and the second pixel electrode, wherein the first emission layer and the second emission layer are disconnected from each other by the trench.

In an embodiment, a width of the trench may be about 5 nm or more and about 200 nm or less.

In an embodiment, the first emission layer and the second emission layer may emit light of a same color.

In an embodiment, in the forming of the pixel defining layer, including the trench, on the first pixel electrode and the second pixel electrode may include forming the pixel defining layer on the first pixel electrode and the second pixel electrode; forming a first opening exposing each of at least a portion of the first pixel electrode and at least a portion of the second pixel electrode in the pixel defining layer; and forming the trench in the pixel defining layer.

In an embodiment, the trench may be spaced apart from the first opening.

In an embodiment, the trench may be spaced apart from the first pixel electrode and the second pixel electrode.

In an embodiment, the method may further include, after the forming of the first emission layer and the second emission layer; forming a first opposite electrode and a second opposite electrode respectively on the first emission layer and the second emission layer; forming an inorganic encapsulation layer in which a second opening exposing at least a portion of each of the first opposite electrode and the second opposite electrode is defined on the first opposite electrode and the second opposite electrode, and forming a connection electrode electrically connecting the first opposite electrode to the second opposite electrode on the first opposite electrode and the second opposite electrode.

In an embodiment, the first opposite electrode and the second opposite electrode may be disconnected from each other by the trench.

In an embodiment, the method may further include forming a dummy emission layer and a dummy opposite electrode inside of the trench.

In an embodiment, the dummy emission layer and the first emission layer may include a same material.

In an embodiment, the dummy opposite electrode and the first opposite electrode may include a same material.

In an embodiment, the forming, on the first opposite electrode and the second opposite electrode, of the inorganic encapsulation layer in which the second opening exposing at least a portion of each of the first opposite electrode and the second opposite electrode is defined may include forming the inorganic encapsulation layer on the first opposite electrode and the second opposite electrode, and forming the second opening in the inorganic encapsulation layer.

In an embodiment, the second opening may at least partially overlap the trench.

In an embodiment, the method may further include forming a first color filter and a second color filter on the inorganic encapsulation layer, wherein the first color filter may at least partially overlap the first emission layer, and the second color filter may at least partially overlap the second emission layer.

At least some of the above and other features of the invention are set out in the claims.

Other aspects, features, and advantages other than those described above will now become apparent from the following drawings, claims, and the detailed description of the disclosure.

### BRIEF DESCRIPTION OF THE DRAWINGS

The above and other aspects, features, and advantages of embodiments will be more apparent from the following description taken in conjunction with the accompanying drawings, in which:
FIGS. 1 and 2 are schematic perspective views each schematically illustrating a display apparatus according to an embodiment;
FIG. 3 is a schematic diagram of an equivalent circuit diagram schematically illustrating a light-emitting diode corresponding to any one pixel of a display apparatus according to an embodiment and a pixel circuit electrically connected to the light-emitting diode;
FIG. 4 is a schematic plan view schematically illustrating a display apparatus according to an embodiment;
FIG. 5 is a schematic cross-sectional view schematically illustrating a display apparatus according to an embodiment;
FIG. 6 is a schematic cross-sectional view schematically illustrating a display apparatus according to an embodiment;
FIG. 7 is a schematic cross-sectional view schematically illustrating a display apparatus according to an embodiment;
FIG. 8 is a schematic cross-sectional view schematically illustrating a display apparatus according to an embodiment;
FIG. 9 is a schematic cross-sectional view schematically illustrating a display apparatus according to an embodiment; and
FIGS. 10 to 19 are schematic cross-sectional views schematically illustrating a method of manufacturing a display apparatus according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, embodiments may have different forms and should not be construed as being limited to the descriptions set forth herein. Accordingly, the embodiments are described below, by referring to the figures, to explain aspects of the description.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Throughout the disclosure, the expression "at least one of a, b or c" indicates only a, only b, only c, both a and b, both a and c, both b and c, all of a, b, and c, or variations thereof.

As the disclosure allows for various changes and numerous embodiments, embodiments will be illustrated in the drawings and described in detail in the written description. Effects and features of the disclosure and methods of achieving the same will be apparent with reference to embodiments and drawings described below in detail. The disclosure may, however, be embodied in many different forms and should not be construed as being limited to the embodiments set forth herein.

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

As used herein, the singular forms, "a," "an," and "the" are intended to include the plural forms as well, unless the context clearly indicates otherwise.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

It will be understood that when a layer, region, or component is referred to as being formed on another layer, region, or component, it can be directly or indirectly formed on the other layer, region, or component. For example, intervening layers, regions, or components may be present.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as `not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

Sizes of components in the drawings may be exaggerated for convenience of explanation. For example, since sizes and thicknesses of components in the drawings are arbitrarily illustrated for convenience of explanation, the following embodiments are not limited thereto.

In the specification, "A and/or B" may include "A," "B," or "A and B." In the specification, "at least one of A and B" may include "A," "B," or "A and B."

In the following embodiments, it will be understood that when a wire is referred to as "extending in a first direction or a second direction," it cannot only extend in a linear shape, but also can extend in the first direction or the second direction in a zigzag or curved line.

In the following embodiments, a "plan view" indicates that a portion of a target object is seen from above, and a "cross-sectional view" indicates that a portion of a target object is vertically cut and the cross-section is viewed from the side. In the following embodiments, a term "overlapping" includes overlapping in a plan view and a cross-sectional view.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

The disclosure will now be described more fully with reference to the accompanying drawings, in which embodiments of the disclosure are shown. Like reference numerals in the drawings denote like elements.

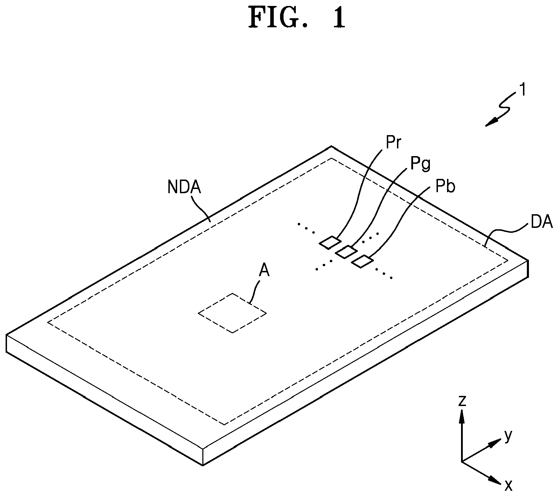

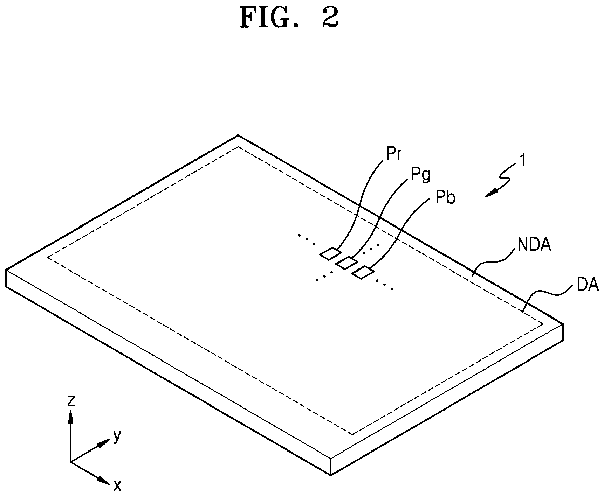

FIGS. 1 and 2 are perspective views each schematically illustrating a display apparatus according to an embodiment.

Referring to FIGS. 1 and 2, a display apparatus 1 may include a display area DA and a non-display area NDA outside the display area DA. First pixels Pr, second pixels Pg, and third pixels Pb may be arranged (or disposed) in the display area DA. The display area DA may display an image through the first pixels Pr, the second pixels Pg, and the third pixels Pb arranged in the display area DA. The non-display area NDA is a non-display area which is arranged outside of the display area DA and does not display an image, and may entirely surround the display area DA. A driver or the like for providing electrical signals or power to the display area DA may be arranged in the non-display area NDA. A pad, which is an area to which an electronic device or a printed circuit board may be electrically connected, may be arranged in the non-display area NDA.

In an embodiment, FIG. 1 shows that the display area DA has a polygonal shape (for example, a rectangular shape) in which a length in an x direction is less than a length in a y direction, but the disclosure is not limited thereto. For example, as shown in FIG. 2, the display area DA may have a polygonal shape (for example, a rectangular shape) in which a length in the y direction is less than a length in the x direction. FIGS. 1 and 2 show that the display area DA is substantially rectangular, but the disclosure is not limited thereto. For example, the display area DA may have various shapes such as an N-polygonal shape (where N is a natural number of 3 or more), a circular shape, or an elliptical shape. FIGS. 1 and 2 show that a corner of the display area DA has a shape in which straight lines meet, but the disclosure is not limited thereto. For example, the display area DA may have a polygonal shape with rounded corners. It is to be understood that the shapes may also include shapes substantial to the shapes disclosed herein.

Hereinafter, for convenience of explanation, a case where the display apparatus 1 is an electronic device that is a smartphone is described, but the display apparatus 1 of the disclosure is not limited thereto. The display apparatus 1 may be a portable electronic device, such as a mobile phone, a smartphone, a table personal computer (PC), a mobile communication terminal, an electronic notebook, an electronic book, a portable multimedia player (PMP), a navigation device, an Ultra Mobile PC (UMPC), or the like, and may also be used in various products, such as a television, a laptop computer, a monitor, an advertisement board, an Internet of things (IoT) device, or the like within the scope of the disclosure. The display apparatus 1 according to an embodiment may be used as a wearable device, such as a smart watch, a watch phone, a glasses-type display, and a head-mounted display (HMD). Also, the display apparatus 1 according to an embodiment may be applied to a dashboard of a vehicle, a center fascia of a vehicle or a center information display (CID) disposed on a dashboard, a rear-view mirror display replacing a side mirror of a vehicle, and a display screen disposed on a back surface of a front seat as entertainment for a passenger in a back seat of a vehicle.

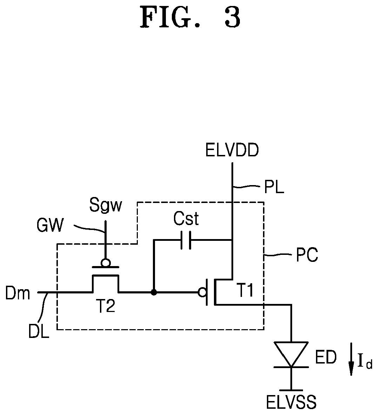

FIG. 3 is a schematic diagram of an equivalent circuit diagram schematically illustrating a light-emitting diode corresponding to any one pixel of a display apparatus according to an embodiment and a pixel circuit electrically connected to the light-emitting diode.

Referring to FIG. 3, a light-emitting diode ED may be electrically connected to a pixel circuit PC, and the pixel circuit PC may include a first transistor T1, a second transistor T2, and a storage capacitor Cst.

The second transistor T2 may transfer, to the first transistor T1, a data signal Dm input through a data line DL according to a scan signal Sgw input through a scan line GW.

The storage capacitor Cst is connected to the second transistor T2 and a driving voltage line PL, and stores a voltage corresponding to a difference between a voltage received from the second transistor T2 and a driving voltage ELVDD supplied to the driving voltage line PL.

The first transistor T1 may be connected to the driving voltage line PL and the storage capacitor Cst, and may control a driving current I_{d} flowing from the driving voltage line PL to the light-emitting diode ED, in accordance to a voltage value stored in the storage capacitor Cst. The light-emitting diode ED may emit light having a given brightness according to the driving current I_{d}. In an embodiment, a common voltage ELVSS may be applied to a second electrode (e.g., a cathode) of the light-emitting diode ED.

Although FIG. 3 illustrates that the pixel circuit PC may include two transistors and one storage capacitor, the disclosure is not limited thereto.

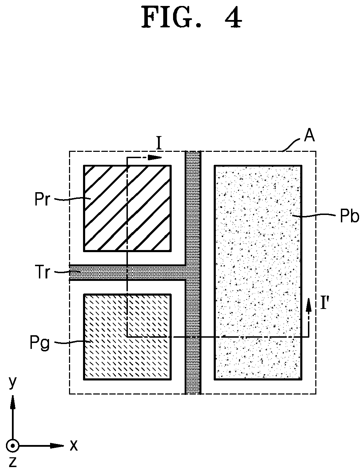

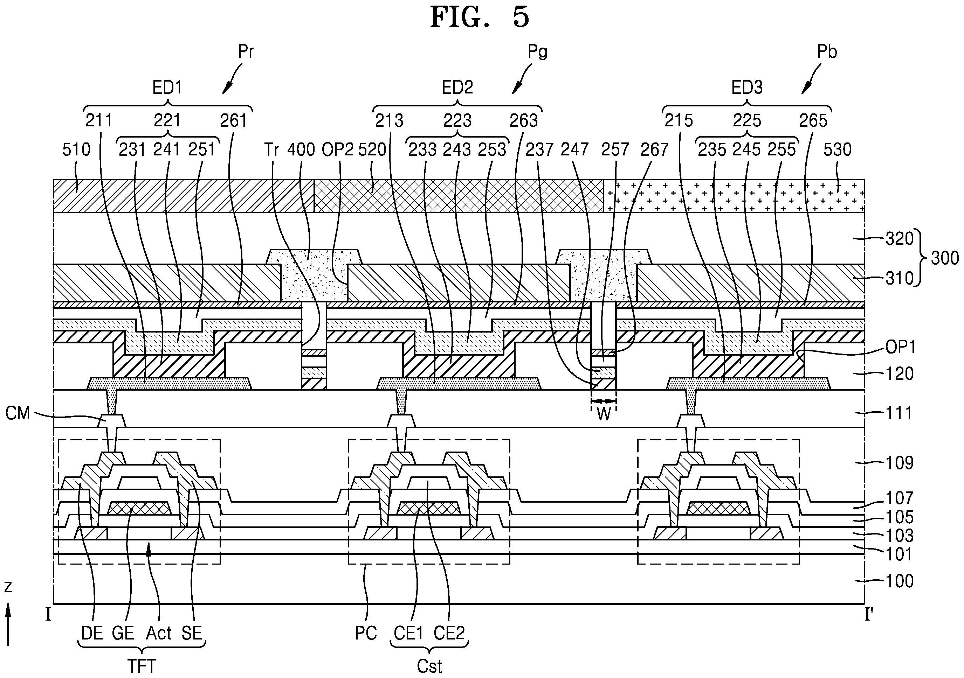

FIG. 4 is a schematic plan view schematically illustrating a display apparatus according to an embodiment. By way of example, FIG. 4 is a diagram schematically illustrating a region A of FIG. 1. FIG. 4 only illustrates a first pixel Pr, a second pixel Pg, a third pixel Pb, and a trench Tr, but this is only for convenience of description and illustration, and FIG. 4 may include members of FIG. 5 to be described below.

Referring to FIG. 4, the first pixel Pr emitting red light, the second pixel Pg emitting green light, and third pixel Pb emitting blue light may be arranged in the display area DA of the display apparatus 1. At this time, first pixels Pr, second pixels Pg, and third pixels Pb may be provided.

In an embodiment, the trench Tr may be arranged between the first pixel Pr and the second pixel Pg, between the second pixel Pg and the third pixel Pb, and between the third pixel Pb and the first pixel Pr. Also, the trench Tr may be arranged between the first pixel Pr and the first pixel Pr, between the second pixel Pg and the second pixel Pg, and between the third pixel Pb and the third pixel Pb. For example, the trench Tr may be arranged between pixels.

In other words, the trench Tr may be arranged along edges of the first pixel Pr, the second pixel Pg, and the third pixel Pb. For example, the trench Tr may be arranged along peripheries of the first pixel Pr, the second pixel Pg, and the third pixel Pb. For example, the trench Tr may be arranged along edges (or peripheries) of pixels.

FIG. 4 shows that an arrangement structure of the first pixel Pr, the second pixel Pg and the third pixel Pb is provided in an S-stripe structure, but the disclosure is not limited thereto. For example, the arrangement structure of the first pixel Pr, the second pixel Pg, and the third pixel Pb may be provided in a stripe structure, a PENTILE^{™} structure, a hexagon structure, or the like within the scope of the disclosure.

FIG. 5 is a schematic cross-sectional view schematically illustrating a display apparatus according to an embodiment. By way of example, FIG. 5 corresponds to a schematic cross-sectional view of the display apparatus taken along line I-I' of FIG. 4.

Referring to FIGS. 4 and 5, the display apparatus according to an embodiment may include a substrate 100, the first pixel Pr disposed on the substrate 100 and including a first pixel electrode 211, a first emission layer 241 disposed on the first pixel electrode 211, and a first opposite electrode 261 disposed on the first emission layer 241, the second pixel Pg disposed on the substrate 100 and including a second pixel electrode 213, a second emission layer 243 disposed on the second pixel electrode 213, and a second opposite electrode 263 disposed on the second emission layer 243, the trench Tr defined between the first pixel Pr and the second pixel Pg, and a connection electrode 400 electrically connecting the first opposite electrode 261 to the second opposite electrode 263.

In an embodiment, the substrate 100 may include silicon (Si). For example, the substrate 100 may be a Si wafer. The substrate 100 may be doped with given conductive impurities as needed. Also, the substrate 100 may include a glass material or a polymer resin. The substrate 100 may include a structure in which a base layer including a polymer resin and an inorganic barrier layer may be stacked on each other. The polymer resin may be polyethersulfone (PES), polyarylate (PAR), polyetherimide (PEI), polyethylene naphthalate (PEN), polyethylene terephthalate (PET), polyphenylene sulfide (PPS), polyallylate, polyimide (PI), polycarbonate, cellulose triacetate (TAC), or cellulose acetate propionate (CAP).

A buffer layer 101 may be disposed on the substrate 100. The buffer layer 101 may prevent impurities from penetrating into a semiconductor layer of a transistor. The buffer layer 101 may include an inorganic insulating material, such as silicon nitride, silicon oxynitride, and silicon oxide, and may include a single layer or a multi-layer, each including the inorganic insulating material stated above.

The pixel circuit PC may be disposed on the buffer layer 101. The pixel circuit PC may include transistors and a storage capacitor, as described above with reference to FIG. 3. In an embodiment, FIG. 5 shows a transistor TFT and the storage capacitor Cst of the pixel circuit PC. However, the disclosure is not limited thereto. The pixel circuit PC may also include seven transistors and one storage capacitor. By way of example, the pixel circuit PC may include five or more transistors and one or more storage capacitors.

The transistor TFT may include a semiconductor layer Act on the buffer layer 101, and a gate electrode GE overlapping a channel area of the semiconductor layer Act. The semiconductor layer Act may include a silicon-based semiconductor material, for example, polysilicon. The semiconductor layer Act may include the channel area, a first area, and a second area, wherein the first area and the second area are respectively arranged on both sides of the channel area. The first area and the second area may each be an area including a higher concentration of impurities than that of the channel area, and any one of the first area and the second area may be a source area, and the other one may correspond to a drain area.

The gate electrode GE may include a conductive material including molybdenum (Mo), aluminium (Al), copper (Cu), titanium (Ti), or the like, and may include a single layer or a multi-layer, each including the material stated above. A gate insulating layer 103 for electrical insulation from the semiconductor layer Act may be disposed below the gate electrode GE. The gate insulating layer 103 may include an inorganic insulating material, such as silicon nitride, silicon oxynitride, and silicon oxide, and may include a single layer or a multi-layer, each including the inorganic insulating material stated above.

The storage capacitor Cst may include a lower electrode CE1 and an upper electrode CE2, which overlap each other. In an embodiment, the lower electrode CE1 of the storage capacitor Cst may include the gate electrode GE. In other words, the gate electrode GE may include the lower electrode CE1 of the storage capacitor Cst. For example, the gate electrode GE and the lower electrode CE1 of the storage capacitor Cst may be an integral body.

A first interlayer insulating layer 105 may be between the lower electrode CE1 and the upper electrode CE2 of the storage capacitor Cst. The first interlayer insulating layer 105 may include an inorganic insulating material, such as silicon oxide, silicon nitride, and silicon oxynitride, and may include a single-layered or multi-layered structure, each including the above inorganic insulating material.

The upper electrode CE2 of the storage capacitor Cst may include a low-resistance conductive material, such as Mo, Al, Cu, and/or Ti, and may include a single-layered or multi-layered structure, each including the above material.

A second interlayer insulating layer 107 may be disposed on the storage capacitor Cst. The second interlayer insulating layer 107 may include an inorganic insulating material, such as silicon oxide, silicon nitride, and silicon oxynitride, and may include a single-layered or multi-layered structure, each including the above inorganic insulating material.

A source electrode SE and/or a drain electrode DE electrically connected to the semiconductor layer Act may be disposed on the second interlayer insulating layer 107. The source electrode SE and/or the drain electrode DE may include Al, Cu, and/or Ti, and may include a single layer or a multi-layer, each including the above material.

A first insulating layer 109 may be disposed on the pixel circuit PC. The first insulating layer 109 may include an inorganic insulating material, such as silicon oxide, silicon nitride, and silicon oxynitride, and may include a single-layered or multi-layered structure, each including the above inorganic insulating material. By way of example, the first insulating layer 109 may include an organic insulating material, such as benzocyclobutene (BCB), polyimide, or hexamethyldisiloxane (HMDSO).

A connection metal CM may be disposed on the first insulating layer 109. The connection metal CM may include Al, Cu, and/or Ti, and may include a single layer or a multi-layer, each including the above material.

A second insulating layer 111 may be arranged between the connection metal CM and the first pixel electrode 211. The second insulating layer 111 may include an inorganic insulating material, such as silicon oxide, silicon nitride, and silicon oxynitride, and may include a single-layered or multi-layered structure, each including the above inorganic insulating material. By way of example, the second insulating layer 111 may include an organic insulating material, such as BCB, polyimide, or HMDSO. According to the embodiment described with reference to FIG. 5, it is shown that the pixel circuit PC and the first pixel electrode 211 are electrically connected to each other through the connection metal CM, but the disclosure is not limited thereto. For example, the connection metal CM may be omitted, and one insulating layer may be between the pixel circuit PC and the first pixel electrode 211. By way of example, three or more insulating layers may be between the pixel circuit PC and the first pixel electrode 211, and the pixel circuit PC and the first pixel electrode 211 may be electrically connected to each other through connection metals.

A first light-emitting diode ED1, a second light-emitting diode ED2, and a third light-emitting diode ED3 may be disposed on the second insulating layer 111. The first light-emitting diode ED1, the second light-emitting diode ED2, and the third light-emitting diode ED3 may each be an organic light-emitting diode.

The first light-emitting diode ED1 may include the first pixel electrode 211, a first intermediate layer 221, and the first opposite electrode 261. At this time, the first intermediate layer 221 may include a first lower functional layer 231, the first emission layer 241, and a first upper functional layer 251. FIG. 5 shows that the first intermediate layer 221 may include one first lower functional layer 231, one first emission layer 241, and one first upper functional layer 251 in a thickness direction of the display apparatus, but the disclosure is not limited thereto. The first intermediate layer 221 may include first lower functional layers 231, first emission layers 241, and first upper functional layers 251 in the thickness direction of the display apparatus. In other words, the first intermediate layer 221 may have a single-stacked structure including a single first emission layer 241, or may have a tandem structure, which is a multi-stacked structure including first emission layers 241. In the case that the first intermediate layer 221 has a tandem structure, a charge generation layer (CGL) may be between adjacent stacks of the multi-stacked structure.

The second light-emitting diode ED2 may include the second pixel electrode 213, a second intermediate layer 223, and the second opposite electrode 263. At this time, the second intermediate layer 223 may include a second lower functional layer 233, the second emission layer 243, and a second upper functional layer 253. FIG. 5 shows that the second intermediate layer 223 may include one second lower functional layer 233, one second emission layer 243, and one second upper functional layer 253 in the thickness direction of the display apparatus, but the disclosure is not limited thereto. The second intermediate layer 223 may include second lower functional layers 233, second emission layers 243, and second upper functional layers 253. In other words, the second intermediate layer 223 may have a single-stacked structure including a single second emission layer 243, or may have a tandem structure, which is a multi-stacked structure including second emission layers 243. In the case that the second intermediate layer 223 has a tandem structure, a CGL may be between adjacent stacks of the multi-stacked structure.

The third light-emitting diode ED3 may include a third pixel electrode 215, a third intermediate layer 225, and a third opposite electrode 265. At this time, the third intermediate layer 225 may include a third lower functional layer 235, a third emission layer 245, and a third upper functional layer 255. FIG. 5 shows that the third intermediate layer 225 may include one third lower functional layer 235, one third emission layer 245, and one third upper functional layer 255 in the thickness direction of the display apparatus, but the disclosure is not limited thereto. The third intermediate layer 225 may include third lower functional layers 235, third emission layers 245, and third upper functional layers 255 in the thickness direction of the display apparatus. In other words, the third intermediate layer 225 may have a single-stacked structure including a single third emission layer 245, or may have a tandem structure, which is a multi-stacked structure including third emission layers 245. In the case that the third intermediate layer 225 has a tandem structure, a CGL may be between adjacent stacks of the multi-stacked structure.

The first pixel electrode 211, the second pixel electrode 213, and the third pixel electrode 215 may be disposed on the second insulating layer 111. The first pixel electrode 211, the second pixel electrode 213, and the third pixel electrode 215 may be spaced apart from each other. The first pixel electrode 211, the second pixel electrode 213, and the third pixel electrode 215 may respectively be anodes of the first pixel Pr, the second pixel Pg, and the third pixel Pb.

The first pixel electrode 211, the second pixel electrode 213, and the third pixel electrode 215 may each be formed to be a (semi)transparent electrode or a reflective electrode. In the case that each of the first pixel electrode 211, the second pixel electrode 213, and the third pixel electrode 215 is formed as a (semi)transparent electrode, each of the first pixel electrode 211, the second pixel electrode 213, and the third pixel electrode 215 may include, for example, indium tin oxide (ITO), indium zinc oxide (IZO), zinc oxide (ZnO), indium oxide (In₂O₃), indium gallium oxide (IGO), or aluminium zinc oxide (AZO). In the case that each of the first pixel electrode 211, the second pixel electrode 213, and the third pixel electrode 215 is formed as a reflective electrode, each of the first pixel electrode 211, the second pixel electrode 213, and the third pixel electrode 215 may include a reflective film such as Ag, Mg, Al, Pt, Pd, Au, Ni, Nd, Ir, Cr or a compound thereof, and may include a film including ITO, IZO, ZnO or In₂O₃ on the reflective film. In an embodiment, the first pixel electrode 211, the second pixel electrode 213, and the third pixel electrode 215 may each have a structure in which an ITO layer, an Ag layer, and an ITO layer may be sequentially stacked on each other. The first pixel electrode 211, the second pixel electrode 213, and the third pixel electrode 215 may each be electrically connected to the connection metal CM through a contact hole of the second insulating layer 111.

A pixel defining layer 120 may be disposed on the first pixel electrode 211, the second pixel electrode 213, the third pixel electrode 215, and the second insulating layer 111. A first opening OP1 may be defined in the pixel defining layer 120. First openings OP1 may be defined in the pixel defining layer 120. The first openings OP1 defined in the pixel defining layer 120 may be spaced apart from each other. At least a portion of each of the first to third pixel electrodes 211, 213, and 215 may be exposed through the first openings OP1 defined in the pixel defining layer 120. For example, at least a portion of each of the first pixel electrode 211, the second pixel electrode 213, and the third pixel electrode 215 may be exposed through the first opening OP1 defined in the pixel defining layer 120. By way of example, at least a portion of the first pixel electrode 211 may be exposed through the first opening OP1 defined in the pixel defining layer 120. At least a portion of the second pixel electrode 213 may be exposed through the first opening OP1 defined in the pixel defining layer 120. At least a portion of the third pixel electrode 215 may be exposed through the first opening OP1 defined in the pixel defining layer 120. For example, at least a portion of one pixel electrode may be exposed through one first opening OP1.

An emission area of a pixel may be defined by the first opening OP1 defined in the pixel defining layer 120. For example, each of a first emission area of the first pixel Pr, a second emission area of the second pixel Pg, and a third emission area of the third pixel Pb may be defined by the first opening OP1 defined in the pixel defining layer 120.

Also, the trench Tr may be formed in the pixel defining layer 120. In other words, the trench Tr may be defined in the pixel defining layer 120. As described above, the trench Tr may be between the first pixel Pr, the second pixel Pg, and the third pixel Pb. In other words, the trench Tr defined in the pixel defining layer 120 may be between the first pixel electrode 211, the second pixel electrode 213, and the third pixel electrode 215. For example, the trench Tr may be between the first pixel electrode 211 and the second pixel electrode 213, between the second pixel electrode 213 and the third pixel electrode 215, and between the third pixel electrode 215 and the first pixel electrode 211. Also, the trench Tr may also be between the first pixel electrode 211 and the first pixel electrode 211, between the second pixel electrode 213 and the second pixel electrode 213, and between the third pixel electrode 215 and the third pixel electrode 215.

The trench Tr may be arranged along peripheries of the first pixel electrode 211, the second pixel electrode 213, and the third pixel electrode 215. In other words, the trench Tr may be arranged along edges of the first pixel electrode 211, the second pixel electrode 213, and the third pixel electrode 215. For example, the trench Tr may be arranged along peripheries (or edges) of pixel electrodes.

The trench Tr may be arranged along peripheries of the first emission area of the first pixel Pr, the second emission area of the second pixel Pg, and the third emission area of the third pixel Pb. For example, the trench Tr may be arranged along the periphery of an emission area and around the emission area without overlapping the emission area of the pixel.

A width W of the trench Tr may be about 5 nm or more and about 200 nm or less. At this time, the width W of the trench Tr may be a distance (or the shortest distance) in a first direction (for example, an x direction) and/or a second direction (for example, a y direction) intersecting the first direction (for example, the x direction). In the case that the width W of the trench Tr is less than about 5 nm, the width W of the trench Tr is too small so that the first emission layer 241 and the second emission layer 243 (or the second emission layer 243 and the third emission layer 245, or the third emission layer 245 and the first emission layer 241) may not be disconnected (or short-circuited, separated, spaced apart) from each other, as to be described below. On the contrary, in the case that the width W of the trench Tr exceeds 200 nm, the width W of the trench Tr is too large so that the connection electrode 400 to be described below is formed inside the trench Tr, and the first emission layer 241 and the second emission layer 243 (or the second emission layer 243 and the third emission layer 245, or the third emission layer 245 and the first emission layer 241) may be electrically connected to each other by the connection electrode 400, and thus color mixing defects may occur.

Accordingly, color mixing defects may be prevented as the first emission layer 241 and the second emission layer 243 (or the second emission layer 243 and the third emission layer 245, or the third emission layer 245 and the first emission layer 241), which are adjacent to each other, may be disconnected (or short-circuited (disconnected), separated, spaced apart) from each other by providing the width W of the trench Tr in a range of about 5 nm or more and about 200 nm or less. For example, color mixing defects may be prevented from occurring as the emission layers are electrically separated from each other by providing the width W of the trench Tr in a range of about 5 nm or more and about 200 nm or less.

The pixel defining layer 120 may include an inorganic insulating material (for example, an inorganic material), such as silicon nitride, silicon oxynitride, and silicon oxide, and may include a single layer or a multi-layer, each including the inorganic insulating material stated above. By way of example, the pixel defining layer 120 may include an organic insulating material (for example, an organic material), such as BCB, polyimide, or HMDSO.

The first lower functional layer 231, the first emission layer 241, the first upper functional layer 251, and the first opposite electrode 261 may be sequentially disposed on the first pixel electrode 211. The second lower functional layer 233, the second emission layer 243, the second upper functional layer 253, and the second opposite electrode 263 may be sequentially disposed on the second pixel electrode 213. Also, the third lower functional layer 235, the third emission layer 245, the third upper functional layer 255, and the third opposite electrode 265 may be sequentially disposed on the third pixel electrode 215.

The first lower functional layer 231, the second lower functional layer 233, and the third lower functional layer 235 may be respectively disposed on the first pixel electrode 211, the second pixel electrode 213, and the third pixel electrode 215. The first lower functional layer 231, the second lower functional layer 233, and the third lower functional layer 235 may respectively overlap the first pixel electrode 211, the second pixel electrode 213, and the third pixel electrode 215. Each of the first lower functional layer 231, the second lower functional layer 233, and the third lower functional layer 235 may include a hole transport layer (HTL) and/or a hole injection layer (HIL). The first lower functional layer 231, the second lower functional layer 233, and the third lower functional layer 235 may include the same material or similar material. However, the disclosure is not limited thereto.

The first lower functional layer 231, the second lower functional layer 233, and the third lower functional layer 235 may be disconnected (or short-circuited (disconnected), separated, spaced apart) from each other by the trench Tr defined in the pixel defining layer 120. For example, the first lower functional layer 231, the second lower functional layer 233, and the third lower functional layer 235 may be electrically separated from each other by the trench Tr. For example, the first lower functional layer 231 and the second lower functional layer 233 may be disconnected (or short-circuited (disconnected), separated, spaced apart) from each other by the trench Tr, so that the first lower functional layer 231 and the second lower functional layer 233 may not be electrically connected to each other. The second lower functional layer 233 and the third lower functional layer 235 may be disconnected (or short-circuited (disconnected), separated, spaced apart) from each other by the trench Tr, so that the second lower functional layer 233 and the third lower functional layer 235 may not be electrically connected to each other. The third lower functional layer 235 and the first lower functional layer 231 may be disconnected (or short-circuited (disconnected), separated, spaced apart) from each other by the trench Tr, so that the third lower functional layer 235 and the first lower functional layer 231 may not be electrically connected to each other. For example, lower functional layers may be disconnected (or short-circuited (disconnected), separated, spaced apart) from each other by the trench Tr, so that the lower functional layers may not be electrically connected to each other.

**A** dummy lower functional layer 237 may be arranged inside the trench Tr defined in the pixel defining layer 120. The dummy lower functional layer 237 may include the same material or similar material as the first lower functional layer 231. The first lower functional layer 231, the dummy lower functional layer 237, and the third lower functional layer 235 may be separated (or spaced apart) from each other by the trench Tr.

The first emission layer 241, the second emission layer 243, and the third emission layer 245 may be respectively disposed on the first lower functional layer 231, the second lower functional layer 233, and the third lower functional layer 235. The first emission layer 241, the second emission layer 243, and the third emission layer 245 may respectively overlap the first lower functional layer 231, the second lower functional layer 233, and the third lower functional layer 235. The first emission layer 241, the second emission layer 243, and the third emission layer 245 may each include a polymer organic material or a low-molecular-weight organic material, which emits light of a given color. For example, the first emission layer 241, the second emission layer 243, and the third emission layer 245 may each include a polymer organic material or a low-molecular-weight organic material, which emits white light. By way of example, the first emission layer 241, the second emission layer 243, and the third emission layer 245 may each include an inorganic material or quantum dots.

The first emission layer 241, the second emission layer 243, and the third emission layer 245 may be disconnected (or short-circuited (disconnected), separated, spaced apart) from each other by the trench Tr defined in the pixel defining layer 120. For example, the first emission layer 241, the second emission layer 243, and the third emission layer 245 may be electrically separated from each other by the trench Tr. For example, the first emission layer 241 and the second emission layer 243 may be disconnected (or short-circuited (disconnected), separated, spaced apart) from each other by the trench Tr, so that the first emission layer 241 and the second emission layer 243 may not be electrically connected to each other. The second emission layer 243 and the third emission layer 245 may be disconnected (or short-circuited (disconnected), separated, spaced apart) from each other by the trench Tr, so that the second emission layer 243 and the third emission layer 245 may not be electrically connected to each other. For example, emission layers may be disconnected (or short-circuited (disconnected), separated, spaced apart) from each other by the trench Tr, so that the emission layers may not be electrically connected to each other.

A dummy emission layer 247 may be arranged inside the trench Tr defined in the pixel defining layer 120. The dummy emission layer 247 may include the same material or similar material as the first emission layer 241. The first emission layer 241, the dummy emission layer 247, and the second emission layer 243 may be separated (or spaced apart) from each other by the trench Tr.

The first upper functional layer 251, the second upper functional layer 253, and the third upper functional layer 255 may be respectively disposed on the first emission layer 241, the second emission layer 243, and the third emission layer 245. The first upper functional layer 251, the second upper functional layer 253, and the third upper functional layer 255 may respectively overlap the first emission layer 241, the second emission layer 243, and the third emission layer 245. The first upper functional layer 251, the second upper functional layer 253, and the third upper functional layer 255 may each include an electron transport layer (ETL) and/or an electron injection layer (EIL).

The first upper functional layer 251, the second upper functional layer 253, and the third upper functional layer 255 may be disconnected (or short-circuited (disconnected), separated, spaced apart) from each other by the trench Tr defined in the pixel defining layer 120. For example, the first upper functional layer 251, the second upper functional layer 253, and the third upper functional layer 255 may be electrically separated from each other by the trench Tr. For example, the first upper functional layer 251 and the second upper functional layer 253 may be disconnected (or short-circuited (disconnected), separated, spaced apart) from each other by the trench Tr, so that the first upper functional layer 251 and the second upper functional layer 253 may be electrically separated from each other. The second upper functional layer 253 and the third upper functional layer 255 may be disconnected (or short-circuited (disconnected), separated, spaced apart) from each other by the trench Tr, so that the second upper functional layer 253 and the third upper functional layer 255 may be electrically separated from each other. The third upper functional layer 255 and the first upper functional layer 251 may be disconnected (or short-circuited (disconnected), separated, spaced apart) from each other by the trench Tr, so that the third upper functional layer 255 and the first upper functional layer 251 may be electrically separated from each other. For example, upper functional layers may be disconnected (or short-circuited (disconnected), separated, spaced apart) from each other by the trench Tr, so that the upper functional layers may not be electrically connected to each other.

A dummy upper functional layer 257 may be arranged inside the trench Tr defined in the pixel defining layer 120. The dummy upper functional layer 257 may include the same material or similar material as the first upper functional layer 251. The first upper functional layer 251, the dummy upper functional layer 257, and the second upper functional layer 253 may be separated (or spaced apart) from each other by the trench Tr.

The first opposite electrode 261, the second opposite electrode 263, and the third opposite electrode 265 may be respectively disposed on the first upper functional layer 251, the second upper functional layer 253, and the third upper functional layer 255. The first opposite electrode 261, the second opposite electrode 263, and the third opposite electrode 265 may respectively overlap the first upper functional layer 251, the second upper functional layer 253, and the third upper functional layer 255. The first opposite electrode 261, the second opposite electrode 263, and the third opposite electrode 265 may respectively be cathodes of the first pixel Pr, the second pixel Pg, and the third pixel Pb.

The first opposite electrode 261, the second opposite electrode 263, and the third opposite electrode 265 may each include a conductive material having a low work function. For example, the first opposite electrode 261, the second opposite electrode 263, and the third opposite electrode 265 may each include a (semi)transparent layer including silver (Ag), magnesium (Mg), Al, platinum (Pt), palladium (Pd), gold (Au), nickel (Ni), neodymium (Nd), iridium (Ir), chromium (Cr), lithium (Li), calcium (Ca), or alloys thereof. By way of example, each of the first opposite electrode 261, the second opposite electrode 263, and the third opposite electrode 265 may further include a layer, such as ITO, IZO, ZnO, or In₂O₃, on the semi(transparent) layer including the above material.

The first opposite electrode 261, the second opposite electrode 263, and the third opposite electrode 265 may be disconnected (or short-circuited (disconnected), separated, spaced apart) from each other by the trench Tr defined in the pixel defining layer 120. For example, the first opposite electrode 261, the second opposite electrode 263, and the third opposite electrode 265 may be electrically separated from each other by the trench Tr. For example, the first opposite electrode 261 and the second opposite electrode 263 may be disconnected (or short-circuited (disconnected), separated, spaced apart) from each other by the trench Tr, so that the first opposite electrode 261 and the second opposite electrode 263 may be electrically separated from each other. The second opposite electrode 263 and the third opposite electrode 265 may be disconnected (or short-circuited (disconnected), separated, spaced apart) from each other by the trench Tr, so that the second opposite electrode 263 and the third opposite electrode 265 may be electrically separated from each other. The third opposite electrode 265 and the first opposite electrode 261 may be disconnected (or short-circuited (disconnected), separated, spaced apart) from each other by the trench Tr, so that the third opposite electrode 265 and the first opposite electrode 261 may be electrically separated from each other. For example, opposite electrodes may be disconnected (or short-circuited (disconnected), separated, spaced apart) from each other by the trench Tr, so that the opposite electrodes may not be electrically connected to each other.

A dummy opposite electrode 267 may be arranged inside the trench Tr defined in the pixel defining layer 120. The dummy opposite electrode 267 may include the same material or similar material as the first opposite electrode 261. The first opposite electrode 261, the dummy opposite electrode 267, and the second opposite electrode 263 may be separated (or spaced apart) from each other by the trench Tr.

An encapsulation layer 300 may be disposed on the first light-emitting diode ED1, the second light-emitting diode ED2, and the third light-emitting diode ED3. By way of example, the encapsulation layer 300 may be disposed on the first opposite electrode 261, the second opposite electrode 263, and the third opposite electrode 265. The encapsulation layer 300 may be a thin-film encapsulation layer. The encapsulation layer 300 may include at least one inorganic insulating material (for example, an inorganic material). The encapsulation layer 300 may include a first inorganic encapsulation layer 310 and a second inorganic encapsulation layer 320. However, the disclosure is not limited thereto. The encapsulation layer 300 may also include an organic encapsulation layer.

The first inorganic encapsulation layer 310 may be disposed on the first opposite electrode 261, the second opposite electrode 263, and the third opposite electrode 265. A second opening OP2 may be defined in the first inorganic encapsulation layer 310. Second openings OP2 may be defined in the first inorganic encapsulation layer 310. The second openings OP2 defined in the first inorganic encapsulation layer 310 may be spaced apart from each other. At least a portion of each of the first to third opposite electrodes 261, 263, and 265 may be exposed through the second openings OP2 defined in the first inorganic encapsulation layer 310. For example, at least a portion of each of the first opposite electrode 261, the second opposite electrode 263, and the third opposite electrode 265 may be exposed through the second opening OP2 defined in the first inorganic encapsulation layer 310. The second opening OP2 may overlap the trench Tr in the thickness direction of the display apparatus. For example, one second opening OP2 may overlap one trench Tr in the thickness direction of the display apparatus. However, the disclosure is not limited thereto.

The connection electrode 400 may be disposed on the first inorganic encapsulation layer 310, the first opposite electrode 261, the second opposite electrode 263, and the third opposite electrode 265. Connection electrodes 400 may be provided. Each connection electrode 400 may be arranged inside the second opening OP2 defined in the first inorganic encapsulation layer 310. For example, one connection electrode 400 may be arranged to correspond to one second opening OP2.

The connection electrode 400 may electrically connect the first opposite electrode 261 and the second opposite electrode 263 to each other. The connection electrode 400 may electrically connect the second opposite electrode 263 and the third opposite electrode 265 to each other. The connection electrode 400 may electrically connect the third opposite electrode 265 and the first opposite electrode 261 to each other. Also, the connection electrode 400 may electrically connect the first opposite electrode 261 and the first opposite electrode 261 to each other, electrically connect the second opposite electrode 263 and the second opposite electrode 263 to each other, and/or electrically connect the third opposite electrode 265 and the third opposite electrode 265 to each other. For example, the connection electrode 400 may electrically connect opposite electrodes spaced apart from each other. The connection electrode 400 may overlap the trench Tr in the thickness direction of the display apparatus. For example, one connection electrode 400 may overlap one trench Tr in the thickness direction of the display apparatus.

The connection electrode 400 may overlap the first to third pixel electrodes 211, 213, and 215 in the thickness direction of the display apparatus. However, the disclosure is not limited thereto. The connection electrode 400 may not overlap the first to third pixel electrodes 211, 213, and 215 in the thickness direction of the display apparatus.

The connection electrode 400 may include a conductive material, such as Al, Ag, Ti, Mo, tungsten (W), or the like within the scope of the disclosure. By way of example, the connection electrode 400 may include a (semi)transparent electrode, such as ITO, IZO, ZnO, In₂O₃, IGO, AZO, or the like within the scope of the disclosure. By way of example, the connection electrode 400 may include a polymer organic material having conductivity.

The second inorganic encapsulation layer 320 may be disposed on the first inorganic encapsulation layer 310 and the connection electrode 400. FIG. 5 shows that the encapsulation layer 300 may include the first inorganic encapsulation layer 310 and the second inorganic encapsulation layer 320, but the disclosure is not limited thereto. The encapsulation layer 300 may also include three or more inorganic encapsulation layers.

A first color filter 510, a second color filter 520, and a third color filter 530 may be disposed on the encapsulation layer 300. The first color filter 510, the second color filter 520, and the third color filter 530 may respectively overlap the first pixel electrode 211, the second pixel electrode 213, and the third pixel electrode 215. In other words, the first color filter 510, the second color filter 520, and the third color filter 530 may respectively overlap the first emission layer 241, the second emission layer 243, and the third emission layer 245.

The first color filter 510 may allow light of a first color (for example, red light) to pass through. First, white light may be emitted from the first emission layer 241, and the white light emitted from the first emission layer 241 may be incident to the first color filter 510. At this time, the first color filter 510 may allow the light of the first color (for example, red light) to pass through. Accordingly, red light may be emitted from the first pixel Pr. In other words, the first color filter 510 may convert incident white light into red light.

The second color filter 520 may allow light of a second color (for example, green light), which may be different from the light of the first color (for example, red light), to pass through. First, white light may be emitted from the second emission layer 243, and the white light emitted from the second emission layer 243 may be incident to the second color filter 520. At this time, the second color filter 520 may allow the light of the second color (green light) to pass through. Accordingly, green light may be emitted from the second pixel Pg. In other words, the second color filter 520 may convert incident white light into green light.

The third color filter 530 may allow light of a third color (for example, blue light), which may be different from the light of the first color (for example, red light), to pass through. First, white light may be emitted from the third emission layer 245, and the white light emitted from the third emission layer 245 may be incident to the third color filter 530. At this time, the third color filter 530 may allow the light of the third color (for example, blue light) to pass through. Accordingly, blue light may be emitted from the third pixel Pb. In other words, the third color filter 530 may convert incident white light into blue light.

Although not illustrated in the drawing, a black matrix may be provided between color filters. By way of example, a black matrix may be provided between the first color filter 510 and the second color filter 520, between the second color filter 520 and the third color filter 530, and between the third color filter 530 and the first color filter 510. An opening may be defined in the black matrix, and the color filters may be arranged inside the opening defined in the black matrix.

The first pixel Pr may include the first color filter 510 and the first light-emitting diode ED1, and the first light-emitting diode ED1 may include the first emission layer 241. The second pixel Pg may include the second color filter 520 and the second light-emitting diode ED2, and the second light-emitting diode ED2 may include the second emission layer 243. The third pixel Pb may include the third color filter 530 and the third light-emitting diode ED3, and the third light-emitting diode ED3 may include the third emission layer 245.

The resolution of a display apparatus may be improved by reducing a distance between pixels. To this end, the first emission layer 241, the second emission layer 243, and the third emission layer 245, which emit white light, may be formed as a common layer (or an integral body), and the first color filter 510, the second color filter 520, and the third color filter 530 may be respectively disposed on the first emission layer 241, the second emission layer 243, and the third emission layer 245. The first color filter 510, the second color filter 520, and the third color filter 530 may respectively convert white light emitted from the first emission layer 241, the second emission layer 243, and the third emission layer 245 into red light, green light, and blue light (or allow red light, green light, and blue light to pass through), and accordingly, red light, green light, and blue light may be respectively emitted from the first pixel Pr, the second pixel Pg, and the third pixel Pb.

**In** order words, to reduce a distance between pixels, a lower functional layer, an emission layer, an upper functional layer, and an opposite electrode may be formed as a common layer (or an integral body), and color filters may be disposed on the common layer, so that light of a desired color may be emitted from each pixel.

However, as adjacent emission layers are electrically connected to each other, even in the case that a given pixel emits light by applying an electrical signal to the given pixel, adjacent pixels may emit light together, and thus color mixing defects may occur.

By way of example, as the first emission layer 241 and the second emission layer 243, which are adjacent to each other, are electrically connected to each other, even in the case that the first pixel Pr emits light by applying an electrical signal to the first pixel Pr, the second pixel Pg may emit light together, and thus color mixing defects may occur. As the second emission layer 243 and the third emission layer 245, which are adjacent to each other, are electrically connected to each other, even in the case that the second pixel Pg emits light by applying an electrical signal to the second pixel Pg, the third pixel Pb may emit light together, and thus color mixing defects may occur. As the third emission layer 245 and the first emission layer 241, which are adjacent to each other, are electrically connected to each other, even in the case that the third pixel Pb emits light by applying an electrical signal to the third pixel Pb, the first pixel Pr may emit light together, and thus color mixing defects may occur.

In the display apparatus according to an embodiment, as the trench Tr is formed in the pixel defining layer 120, and the first emission layer 241 and the second emission layer 243 (or the second emission layer 243 and the third emission layer 245, or the third emission layer 245 and the first emission layer 241) are electrically disconnected (short-circuited (disconnected), separated, spaced apart) from each other through the trench Tr, occurrence of color mixing defects may be prevented.

However, in the case that the trench Tr is formed in the pixel defining layer 120, the first opposite electrode 261 and the second opposite electrode 263 (or the second opposite electrode 263 and the third opposite electrode 265, or the third opposite electrode 265 and the first opposite electrode 261) are electrically disconnected (short-circuited (disconnected), separated, spaced apart) from each other through the trench Tr. The first opposite electrode 261 and the second opposite electrode 263 (or the second opposite electrode 263 and the third opposite electrode 265, or the third opposite electrode 265 and the first opposite electrode 261), which are electrically disconnected (short-circuited (disconnected), separated, spaced apart) from each other, may be electrically connected to each other through the connection electrode 400. For example, opposite electrodes, which are electrically separated from each other, may be electrically connected to each other through the connection electrode 400.

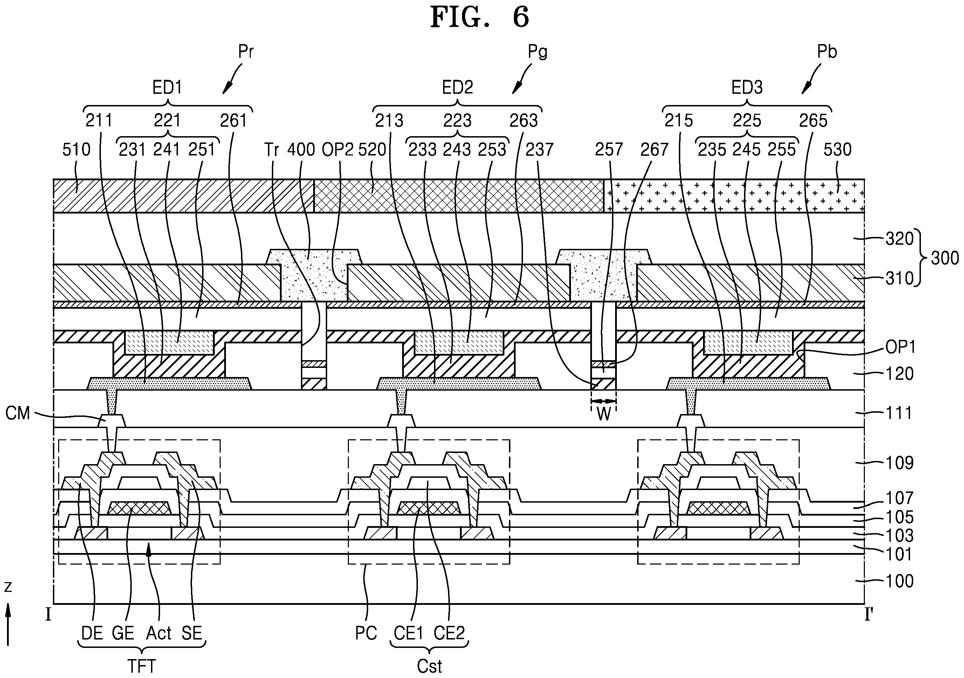

FIG. 6 is a schematic cross-sectional view schematically illustrating a display apparatus according to an embodiment. The embodiment of FIG. 6 may be different from the embodiment of FIG. 5 in that emission layers emit light of different colors. In FIG. 6, the same reference numerals as those in FIG. 5 refer to the same members, and redundant descriptions thereof are omitted.

Referring to FIG. 6, the first emission layer 241, the second emission layer 243, and the third emission layer 245 may be respectively disposed on the first lower functional layer 231, the second lower functional layer 233, and the third lower functional layer 235. The first emission layer 241, the second emission layer 243, and the third emission layer 245 may respectively overlap the first lower functional layer 231, the second lower functional layer 233, and the third lower functional layer 235. Each of the first emission layer 241, the second emission layer 243, and the third emission layer 245 may be respectively arranged inside the first openings OP1 defined in the pixel defining layer 120.

The first emission layer 241, the second emission layer 243, and the third emission layer 245 may each include a polymer organic material or a low-molecular-weight organic material, which emits light of a given color (red, green, or blue). For example, the first emission layer 241 may emit red light, the second emission layer 243 may emit green light, and the third emission layer 245 may emit blue light. For example, the first emission layer 241, the second emission layer 243, and the third emission layer 245 may respectively emit light of different colors.

The first emission layer 241, the second emission layer 243, and the third emission layer 245 may be spaced apart from each other. By way of example, the first emission layer 241 and the second emission layer 243 may be spaced apart from each other, the second emission layer 243 and the third emission layer 245 may be spaced apart from each other, and the third emission layer 245 and the first emission layer 241 may be spaced apart from each other. For example, the first emission layer 241, the second emission layer 243, and the third emission layer 245 may be disconnected (or short-circuited (disconnected), separated, spaced apart) from each other.

The dummy lower functional layer 237, the dummy upper functional layer 257, and the dummy opposite electrode 267 may be arranged inside the trench Tr defined in the pixel defining layer 120.

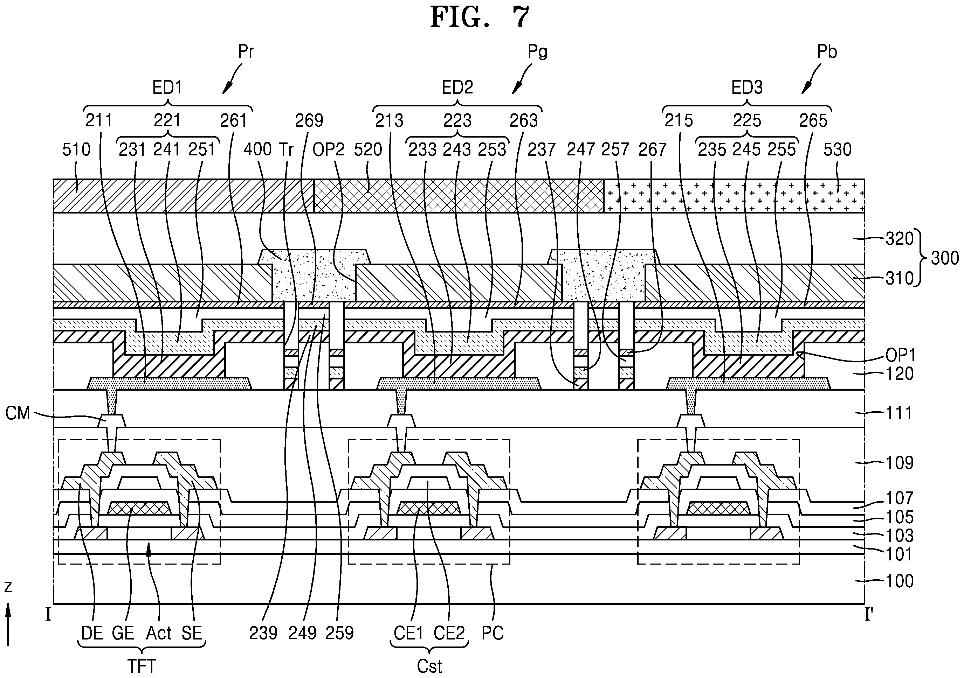

FIG. 7 is a schematic cross-sectional view schematically illustrating a display apparatus according to an embodiment. The embodiment of FIG. 7 may be different from the embodiment of FIG. 5 in that trenches are formed. In FIG. 7, the same reference numerals as those in FIG. 5 refer to the same members, and redundant descriptions thereof are omitted.

Referring to FIG. 7, the first pixel electrode 211, the second pixel electrode 213, and the third pixel electrode 215 may be disposed on the second insulating layer 111. The first pixel electrode 211, the second pixel electrode 213, and the third pixel electrode 215 may be spaced apart from each other.

The pixel defining layer 120 may be disposed on the first pixel electrode 211, the second pixel electrode 213, the third pixel electrode 215, and the second insulating layer 111. The first opening OP1 may be defined in the pixel defining layer 120. First openings OP1 may be provided.

In an embodiment, trenches Tr may be formed (or defined) in the pixel defining layer 120. For example, the trenches Tr may be provided between pixels emitting light of different colors.

By way of example, the trenches Tr may be provided between the first pixel Pr and the second pixel Pg. For example, the trenches Tr may be provided in the pixel defining layer 120 between the first pixel Pr and the second pixel Pg. FIG. 7 shows that two trenches Tr are provided in the pixel defining layer 120 between the first pixel Pr and the second pixel Pg, but the disclosure is not limited thereto. Three or more trenches Tr may also be provided in the pixel defining layer 120 between the first pixel Pr and the second pixel Pg, but the disclosure is not limited thereto. A short circuit effect of the first to third intermediate layers 221, 223, and 225 may be increased by providing the trenches Tr in the pixel defining layer 120.

The trenches Tr may be provided between the second pixel Pg and the third pixel Pb. For example, the trenches Tr may be provided in the pixel defining layer 120 between the second pixel Pg and the third pixel Pb. FIG. 7 shows that two trenches Tr are provided in the pixel defining layer 120 between the second pixel Pg and the third pixel Pb, but the disclosure is not limited thereto. Three of more trenches Tr may also be provided in the pixel defining layer 120 between the second pixel Pg and the third pixel Pb.

Also, the trenches Tr may be provided between the third pixel Pb and the first pixel Pr, between the first pixel Pr and the first pixel Pr, between the second pixel Pg and the second pixel Pg, and/or between the third pixel Pb and the third pixel Pb.

The first lower functional layer 231, the second lower functional layer 233, and the third lower functional layer 235 may be respectively disposed on the first pixel electrode 211, the second pixel electrode 213, and the third pixel electrode 215, and the first emission layer 241, the second emission layer 243, and the third emission layer 245 may be respectively disposed on the first lower functional layer 231, the second lower functional layer 233, and the third lower functional layer 235. Also, the first upper functional layer 251, the second upper functional layer 253, and the third upper functional layer 255 may be respectively disposed on the first emission layer 241, the second emission layer 243, and the third emission layer 245, and the first opposite electrode 261, the second opposite electrode 263, and the third opposite electrode 265 may be respectively disposed on the first upper functional layer 251, the second upper functional layer 253, and the third upper functional layer 255.

The dummy lower functional layer 237, the dummy emission layer 247, the dummy upper functional layer 257, and the dummy opposite electrode 267 may be arranged inside the trenches Tr defined in the pixel defining layer 120.

A fourth lower functional layer 239, a fourth emission layer 249, a fourth upper functional layer 259, and a fourth opposite electrode 269 may be disposed on the pixel defining layer 120 between the trenches Tr. The fourth lower functional layer 239, the fourth emission layer 249, the fourth upper functional layer 259, and the fourth opposite electrode 269 may respectively include the same materials or similar materials as the first lower functional layer 231, the first emission layer 241, the first upper functional layer 251, and the first opposite electrode 261.

The first inorganic encapsulation layer 310 may be disposed on the first opposite electrode 261, the second opposite electrode 263, the third opposite electrode 265, and the fourth opposite electrode 269. The second opening OP2 may be defined in the first inorganic encapsulation layer 310. The second openings OP2 may be defined in the first inorganic encapsulation layer 310. The second openings OP2 defined in the first inorganic encapsulation layer 310 may be spaced apart from each other. At least a portion of each of the first opposite electrode 261, the second opposite electrode 263, and the third opposite electrode 265 may be exposed through the second opening OP2 defined in the first inorganic encapsulation layer 310. Also, at least a portion of the fourth opposite electrode 269 may be exposed through the second opening OP2 defined in the first inorganic encapsulation layer 310.

One second opening OP2 may overlap the trenches Tr in the thickness direction of the display apparatus. For example, as shown in FIG. 7, one second opening OP2 may overlap two trenches Tr in the thickness direction of the display apparatus. However, the disclosure is not limited thereto. One second opening OP2 may overlap three or more trenches Tr in the thickness direction of the display apparatus.

The connection electrode 400 may be disposed on the first inorganic encapsulation layer 310, the first opposite electrode 261, the second opposite electrode 263, the third opposite electrode 265, and the fourth opposite electrode 269. Connection electrodes 400 may be provided. The connection electrode 400 may be arranged inside the second opening OP2. For example, one connection electrode 400 may be arranged to correspond to one second opening OP2.

Opposite electrodes may be electrically connected to each other through the connection electrode 400. For example, the first opposite electrode 261 and the second opposite electrode 263 may be electrically connected to each other through the connection electrode 400, the second opposite electrode 263 and the third opposite electrode 265 may be electrically connected to each other through the connection electrode 400, and the third opposite electrode 265 and the first opposite electrode 261 may be electrically connected to each other through the connection electrode 400.

One connection electrode 400 may overlap the trenches Tr in the thickness direction of the display apparatus. For example, as shown in FIG. 7, the connection electrode 400 may overlap two trenches Tr in the thickness direction of the display apparatus. However, the disclosure is not limited thereto. One connection electrode 400 may overlap three or more trenches Tr in the thickness direction of the display apparatus.

A short circuit effect of the first to third intermediate layers 221, 223, and 225 may be increased by providing the trenches Tr in the pixel defining layer 120. For example, the first emission layer 241 and the second emission layer 243 (or the second emission layer 243 and the third emission layer 245, or the third emission layer 245 and the first emission layer 241) may be disconnected (or short-circuited (disconnected), separated, spaced apart) from each other by providing the trenches Tr in the pixel defining layer 120. The short circuit effect of the first to third lower functional layers 231, 233, and 235 and the first to third upper functional layers 251, 253, and 255 may also be increased.

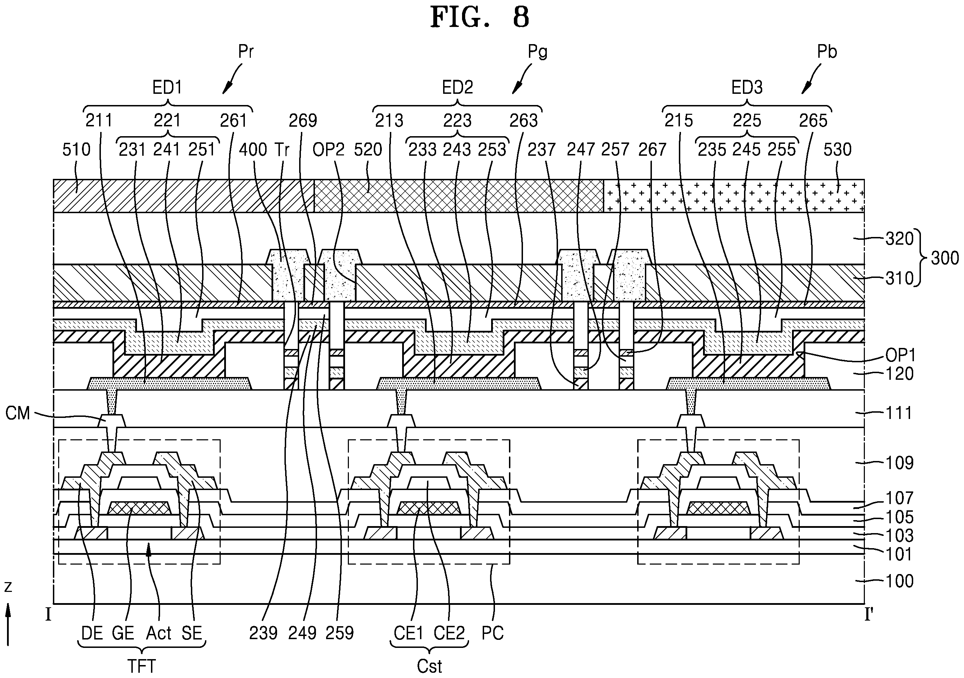

FIG. 8 is a schematic cross-sectional view schematically illustrating a display apparatus according to an embodiment. The embodiment of FIG. 8 may be different from the embodiment of FIG. 7 in that connection electrodes are provided. In FIG. 8, the same reference numerals as those in FIG. 7 refer to the same members, and redundant descriptions thereof are omitted.

Referring to FIGS. 5, 7, and 8, the trenches Tr may be formed (or defined) in the pixel defining layer 120. For example, the trenches Tr may be provided between pixels emitting light of different colors.

The first lower functional layer 231, the second lower functional layer 233, and the third lower functional layer 235 may be respectively disposed on the first pixel electrode 211, the second pixel electrode 213, and the third pixel electrode 215, and the first emission layer 241, the second emission layer 243, and the third emission layer 245 may be respectively disposed on the first lower functional layer 231, the second lower functional layer 233, and the third lower functional layer 235. Also, the first upper functional layer 251, the second upper functional layer 253, and the third upper functional layer 255 may be respectively disposed on the first emission layer 241, the second emission layer 243, and the third emission layer 245, and the first opposite electrode 261, the second opposite electrode 263, and the third opposite electrode 265 may be respectively disposed on the first upper functional layer 251, the second upper functional layer 253, and the third upper functional layer 255.

The dummy lower functional layer 237, the dummy emission layer 247, the dummy upper functional layer 257, and the dummy opposite electrode 267 may be arranged inside the trenches Tr defined in the pixel defining layer 120.

The fourth lower functional layer 239, the fourth emission layer 249, the fourth upper functional layer 259, and the fourth opposite electrode 269 may be disposed on the pixel defining layer 120 between the trenches Tr. The fourth lower functional layer 239, the fourth emission layer 249, the fourth upper functional layer 259, and the fourth opposite electrode 269 may respectively include the same materials or similar materials as the first lower functional layer 231, the first emission layer 241, the first upper functional layer 251, and the first opposite electrode 261.

The first inorganic encapsulation layer 310 may be disposed on the first opposite electrode 261, the second opposite electrode 263, the third opposite electrode 265, and the fourth opposite electrode 269. The second opening OP2 may be defined in the first inorganic encapsulation layer 310. The second openings OP2 may be formed (or defined) in the first inorganic encapsulation layer 310. For example, the second openings OP2 may be provided between pixels emitting light of different colors.

By way of example, the second openings OP2 may be provided between the first pixel Pr and the second pixel Pg. For example, the second openings OP2 may be provided in the first inorganic encapsulation layer 310 between the first pixel Pr and the second pixel Pg. FIG. 8 shows that two second openings OP2 are provided in the first inorganic encapsulation layer 310 between the first pixel Pr and the second pixel Pg, but the disclosure is not limited thereto. Three or more second openings OP2 may be provided in the first inorganic encapsulation layer 310 between the first pixel Pr and the second pixel Pg.

The second openings OP2 may be provided between the second pixel Pg and the third pixel Pb. For example, the second openings OP2 may be provided in the first inorganic encapsulation layer 310 between the second pixel Pg and the third pixel Pb. FIG. 8 shows that two second openings OP2 are provided in the first inorganic encapsulation layer 310 between the second pixel Pg and the third pixel Pb. Three or more second openings OP2 may also be provided in the first inorganic encapsulation layer 310 between the second pixel Pg and the third pixel Pb.

Also, the second openings OP2 may be provided between the third pixel Pb and the first pixel Pr, between the first pixel Pr and the first pixel Pr, between the second pixel Pg and the second pixel Pg, and between the third pixel Pb and the third pixel Pb.

One second opening OP2 may overlap one trench Tr in the thickness direction of the display apparatus. However, the disclosure is not limited thereto.

At least a portion of each of the first opposite electrode 261, the second opposite electrode 263, and the fourth opposite electrode 269 may be exposed through the second opening OP2 defined in the first inorganic encapsulation layer 310. For example, at least a portion of each of the first opposite electrode 261 and the fourth opposite electrode 269 may be exposed through one second opening OP2 defined in the first inorganic encapsulation layer 310, and at least a portion of each of the fourth opposite electrode 269 and the second opposite electrode 263 may be exposed through another one second opening OP2 defined in the first inorganic encapsulation layer 310.

The connection electrode 400 may be disposed on the first inorganic encapsulation layer 310, the first opposite electrode 261, the second opposite electrode 263, the third opposite electrode 265, and the fourth opposite electrode 269. The connection electrodes 400 may be provided. The connection electrode 400 may be arranged inside the second opening OP2. For example, one connection electrode 400 may be arranged to correspond to one second opening OP2.

In an embodiment, the first opposite electrode 261 and the fourth opposite electrode 269 may be electrically connected to each other through one connection electrode 400, and the fourth opposite electrode 269 and the second opposite electrode 263 may be electrically connected to each other through another one connection electrode 400. Accordingly, the first opposite electrode 261 and the second opposite electrode 263, which are spaced apart from each other, may be electrically connected to each other through the above method.

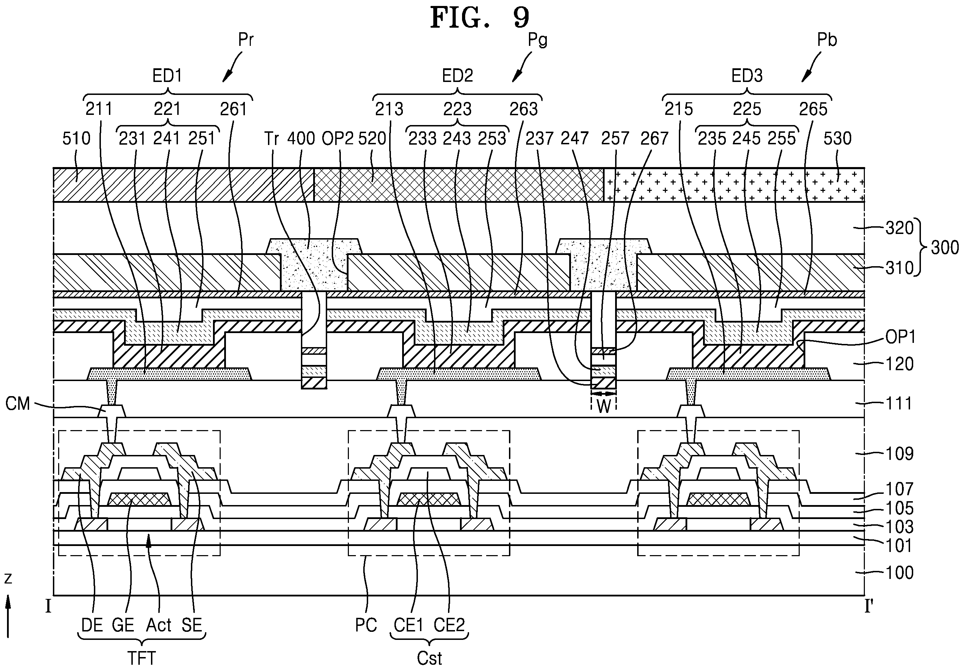

FIG. 9 is a schematic cross-sectional view schematically illustrating a display apparatus according to an embodiment. The embodiment of FIG. 9 may be different from the embodiment of FIG. 5 in that at least a portion of a trench is formed in a second insulating layer. In FIG. 9, the same reference numerals as those in FIG. 5 refer to the same members, and redundant descriptions thereof are omitted.

Referring to FIGS. 5 and 9, the first pixel electrode 211, the second pixel electrode 213, and the third pixel electrode 215 may be disposed on the second insulating layer 111. The first pixel electrode 211, the second pixel electrode 213, and the third pixel electrode 215 may be spaced apart from each other.

The pixel defining layer 120 may be disposed on the first pixel electrode 211, the second pixel electrode 213, the third pixel electrode 215, and the second insulating layer 111. The first opening OP1 may be defined in the pixel defining layer 120. First openings OP1 may be provided.

Also, the trench Tr may be formed in the pixel defining layer 120. In other words, the trench Tr may be defined in the pixel defining layer 120. In an embodiment, the trench Tr may also be formed in the second insulating layer 111. In other words, the trench Tr may also be defined in the second insulating layer 111. For example, the trench Tr may be formed in the pixel defining layer 120 and at least a portion of the second insulating layer 111. In other words, the trench Tr may be defined in the pixel defining layer 120 and at least a portion of the second insulating layer 111.

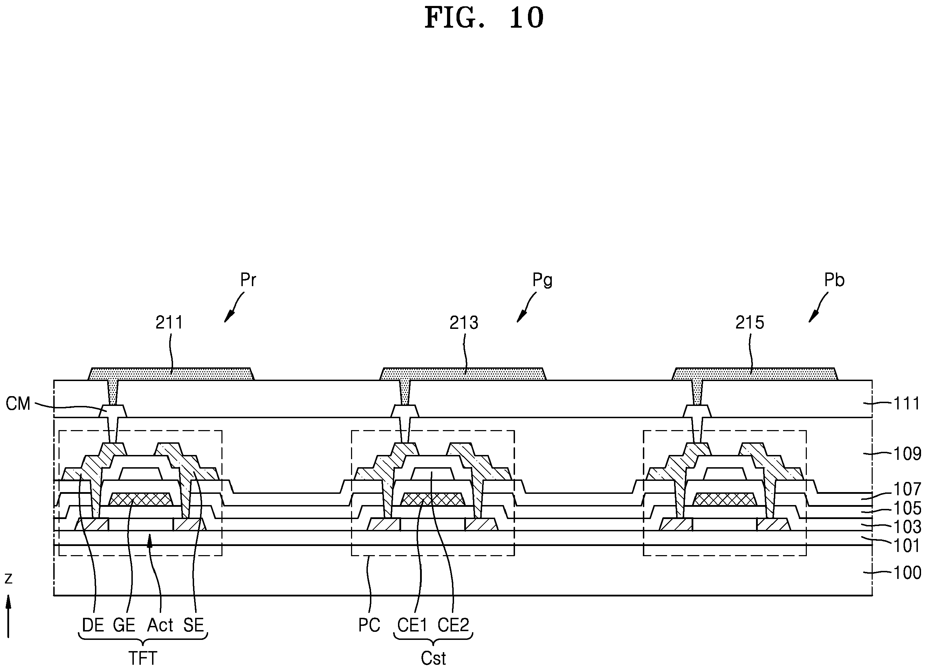

FIGS. 10 to 19 are schematic cross-sectional views schematically illustrating a method of manufacturing a display apparatus according to an embodiment. By way of example, FIGS. 10 to 19 show processes of manufacturing the display apparatus of FIG. 5. In FIGS. 10 to 19, the same reference numerals as those in FIG. 5 refer to the same members. Hereinafter, a method of manufacturing a display apparatus is described with reference to FIGS. 10 to 19.

Referring to FIGS. 10 to 19, a method of manufacturing a display apparatus may include forming the first pixel electrode 211 and the second pixel electrode 213 on the substrate 100, forming, on the first pixel electrode 211 and the second pixel electrode 213, the pixel defining layer 120 in which the first opening OP1 and the trench Tr, which expose at least a portion of the first pixel electrode 211 and the second pixel electrode 213, are defined, forming the first emission layer 241 and the second emission layer 243 respectively on the first pixel electrode 211 and the second pixel electrode 213, forming the first opposite electrode 261 and the second opposite electrode 263 respectively on the first emission layer 241 and the second emission layer 243, forming, on the first opposite electrode 261 and the second opposite electrode 263, the first inorganic encapsulation layer 310 in which the second opening OP2, which exposes at least a portion of the first opposite electrode 261 and the second opposite electrode 263, is defined, and forming the connection electrode 400 electrically connecting the first opposite electrode 261 to the second opposite electrode 263 on the first opposite electrode 261 and the second opposite electrode 263.

First, referring to FIG. 10, the buffer layer 101 may be formed on the substrate 100, and the pixel circuit PC may be formed on the buffer layer 101. The pixel circuit PC may include the transistor TFT and the storage capacitor Cst. The transistor TFT may include the semiconductor layer Act, the gate electrode GE, the source electrode SE, and the drain electrode DE, and the storage capacitor Cst may include the lower electrode CE1 and the upper electrode CE2.

The semiconductor layer Act may be formed on the buffer layer 101, the gate insulating layer 103 may be formed on the semiconductor layer Act, the gate electrode GE may be formed on the gate insulating layer 103, and the first interlayer insulating layer 105 may be formed on the gate electrode GE. Also, the upper electrode CE2 may be formed on the first interlayer insulating layer 105, the second interlayer insulating layer 107 may be formed on the upper electrode CE2, and the source electrode SE and/or the drain electrode DE may be formed on the second interlayer insulating layer 107. The first insulating layer 109 may be formed on the source electrode SE and/or the drain electrode DE, the connection metal CM may be formed on the first insulating layer 109, and the second insulating layer 111 may be formed on the connection metal CM.

The gate insulating layer 103, the first interlayer insulating layer 105, the second interlayer insulating layer 107, the first insulating layer 109, and the second insulating layer 111 may each include an inorganic insulating material, such as silicon oxide, silicon nitride, and silicon oxynitride, and may include a single-layered structure or a multi-layered structure, each including the above inorganic insulating material. However, the disclosure is not limited thereto. At least one of the gate insulating layer 103, the first interlayer insulating layer 105, the second interlayer insulating layer 107, the first insulating layer 109, and the second insulating layer 111 may also include an organic insulating material.

The first pixel electrode 211, the second pixel electrode 213, and the third pixel electrode 215 may be formed on the second insulating layer 111. The first pixel electrode 211, the second pixel electrode 213, and the third pixel electrode 215 may be spaced apart from each other.

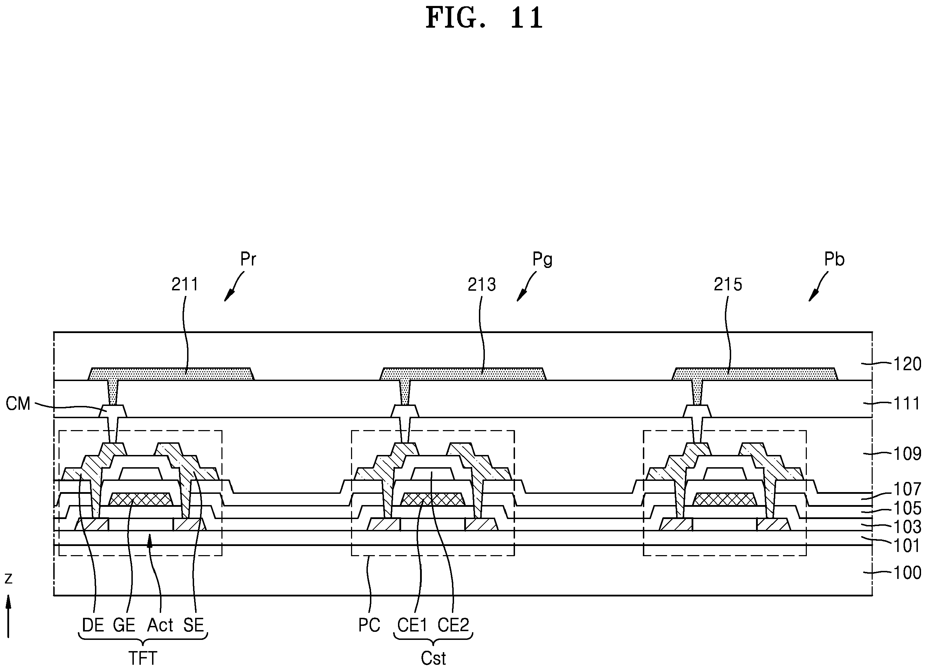

Referring to FIG. 11, the pixel defining layer 120 may be formed on the first pixel electrode 211, the second pixel electrode 213, the third pixel electrode 215, and the second insulating layer 111. The pixel defining layer 120 may include an inorganic insulating material, such as silicon nitride, silicon oxynitride, and silicon oxide, and may include a single layer or a multi-layer, each including the inorganic insulating material stated above. However, the disclosure is not limited thereto. The pixel defining layer 120 may also include an organic insulating material, such as BCB, polyimide, or HMDSO.

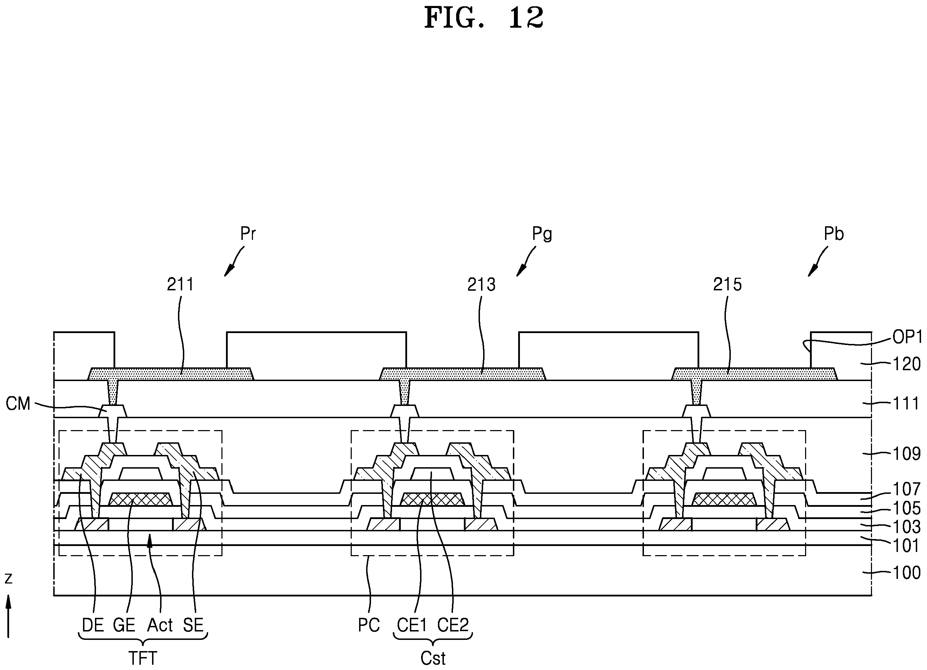

Referring to FIG. 12, the first opening OP1 may be defined in the pixel defining layer 120. The first openings OP1 may be provided. The first opening OP1 defined in the pixel defining layer 120 may expose at least a portion of each of the first pixel electrode 211, the second pixel electrode 213, and the third pixel electrode 215. An emission area of a pixel may be defined by the first opening OP1 defined in the pixel defining layer 120.

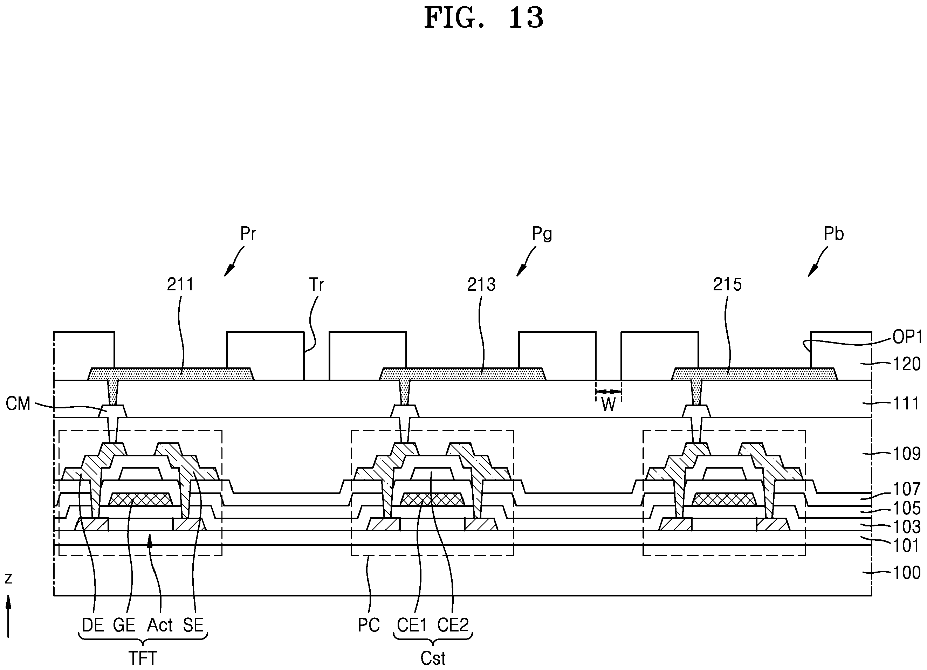

Referring to FIG. 13, the trench Tr may be defined in the pixel defining layer 120. By way of example, the trench Tr may be formed in the pixel defining layer 120 after the first opening OP1 is formed in the pixel defining layer 120.

The first opening OP1 and the trench Tr may be defined in the pixel defining layer 120. The trench Tr defined in the pixel defining layer 120 may be spaced apart from the first opening OP1 defined in the pixel defining layer 120.

The trench Tr defined in the pixel defining layer 120 may be provided between the first pixel electrode 211 and the second pixel electrode 213, between the second pixel electrode 213 and the third pixel electrode 215, and between the third pixel electrode 215 and the first pixel electrode 211. Also, although not illustrated in the drawing, the trench Tr defined in the pixel defining layer 120 may be provided between the first pixel electrode 211 and the first pixel electrode 211, between the second pixel electrode 213 and the second pixel electrode 213, and between the third pixel electrode 215 and the third pixel electrode 215.

As described above, the trench Tr may be arranged along peripheries of the first pixel electrode 211, the second pixel electrode 213, and the third pixel electrode 215. In other words, the trench Tr may be arranged along edges of the first pixel electrode 211, the second pixel electrode 213, and the third pixel electrode 215. For example, the trench Tr may be arranged along peripheries (or edges) of pixel electrodes.

As described above, the width W of the trench Tr may be about 5 nm or more and about 200 nm or less.

The first opening OP1 and the trench Tr may be formed in different processes. By way of example, after the first openings OP1 are firstly defined in the pixel defining layer 120, the trench Tr may be defined in the pixel defining layer 120 in which the first openings OP1 are defined. However, the disclosure is not limited thereto. For example, the first openings OP1 and the trench Tr may be formed in the same process. By way of example, the first openings OP1 and the trench Tr may also be simultaneously formed in the pixel defining layer 120.

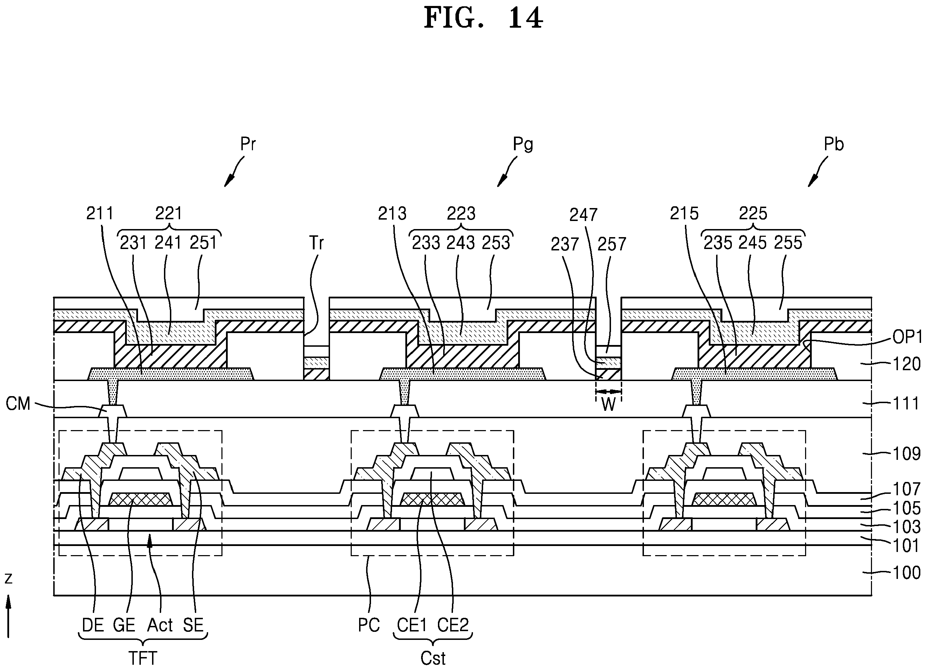

Referring to FIG. 14, the first intermediate layer 221, the second intermediate layer 223, and the third intermediate layer 225 may be respectively formed on the first pixel electrode 211, the second pixel electrode 213, and the third pixel electrode 215.

Firstly, the first lower functional layer 231, the second lower functional layer 233, and the third lower functional layer 235 may be respectively formed on the first pixel electrode 211, the second pixel electrode 213, and the third pixel electrode 215. At this time, the first lower functional layer 231, the second lower functional layer 233, and the third lower functional layer 235 may be disconnected (or short-circuited (disconnected), separated, spaced apart) from each other.

The first lower functional layer 231, the second lower functional layer 233, and the third lower functional layer 235 may be deposited without a separate mask. The first lower functional layer 231, the second lower functional layer 233, and the third lower functional layer 235 may be simultaneously formed in the same process. The first lower functional layer 231, the second lower functional layer 233, and the third lower functional layer 235 may include the same material or a similar material.

Because the first lower functional layer 231, the second lower functional layer 233, and the third lower functional layer 235 are deposited without a separate mask, in the case that the trench Tr is not formed (or provided) in the pixel defining layer 120, the first lower functional layer 231, the second lower functional layer 233, and the third lower functional layer 235 may be electrically connected to (or in contact with) each other.

However, in the disclosure, as the trench Tr is formed (or provided) in the pixel defining layer 120, even in the case that the first lower functional layer 231, the second lower functional layer 233, and the third lower functional layer 235 are deposited without a separate mask, the first lower functional layer 231, the second lower functional layer 233, and the third lower functional layer 235 may be disconnected (or short-circuited (disconnected), separated, spaced apart) from each other. For example, through the trench Tr defined in the pixel defining layer 120, lower functional layers may be spaced apart from each other without being electrically connected to each other.

At this time, the dummy lower functional layer 237 may be formed inside the trench Tr. The dummy lower functional layer 237 may include the same material or similar material as the first lower functional layer 231.

The first emission layer 241, the second emission layer 243, and the third emission layer 245 may be respectively formed on the first lower functional layer 231, the second lower functional layer 233, and the third lower functional layer 235. At this time, the first emission layer 241, the second emission layer 243, and the third emission layer 245 may be disconnected (or short-circuited (disconnected), separated, spaced apart) from each other.

The first emission layer 241, the second emission layer 243, and the third emission layer 245 may be deposited without a separate mask. The first emission layer 241, the second emission layer 243, and the third emission layer 245 may be simultaneously formed in the same process. The first emission layer 241, the second emission layer 243, and the third emission layer 245 may include the same material or similar material. In other words, the first emission layer 241, the second emission layer 243, and the third emission layer 245 may emit light of the same color. For example, the first emission layer 241, the second emission layer 243, and the third emission layer 245 may emit white light.

Because the first emission layer 241, the second emission layer 243, and the third emission layer 245 are deposited without a separate mask, in the case that the trench Tr is not formed (or provided) in the pixel defining layer 120, the first emission layer 241, the second emission layer 243, and the third emission layer 245 may be directly connected to (or in contact with) each other.

However, in the disclosure, as the trench Tr is formed (or provided) in the pixel defining layer 120, even in the case that the first emission layer 241, the second emission layer 243, and the third emission layer 245 are deposited without a separate mask, the first emission layer 241, the second emission layer 243, and the third emission layer 245 may be disconnected (or short-circuited (disconnected), separated, spaced apart) from each other. For example, through the trench Tr defined in the pixel defining layer 120, emission layers may be spaced apart from each other without being connected to each other.

At this time, the dummy emission layer 247 may be formed inside the trench Tr. The dummy emission layer 247 may be formed on the dummy lower functional layer 237. The dummy emission layer 247 may include the same material or similar material as the first emission layer 241.

The first upper functional layer 251, the second upper functional layer 253, and the third upper functional layer 255 may be respectively formed on the first emission layer 241, the second emission layer 243, and the third emission layer 245. At this time, the first upper functional layer 251, the second upper functional layer 253, and the third upper functional layer 255 may be disconnected (or short-circuited (disconnected), separated, spaced apart) from each other.

The first upper functional layer 251, the second upper functional layer 253, and the third upper functional layer 255 may be deposited without a separate mask. The first upper functional layer 251, the second upper functional layer 253, and the third upper functional layer 255 may be simultaneously formed in the same process. The first upper functional layer 251, the second upper functional layer 253, and the third upper functional layer 255 may include the same material or similar material.

Because the first upper functional layer 251, the second upper functional layer 253, and the third upper functional layer 255 are deposited without a separate mask, in the case that the trench Tr is not formed in the pixel defining layer 120, the first upper functional layer 251, the second upper functional layer 253, and the third upper functional layer 255 may be electrically connected to (or in contact with) each other.

However, in the disclosure, as the trench Tr is formed (or provided) in the pixel defining layer 120, even in the case that the first upper functional layer 251, the second upper functional layer 253, and the third upper functional layer 255 are deposited without a separate mask, the first upper functional layer 251, the second upper functional layer 253, and the third upper functional layer 255 may be disconnected (or short-circuited (disconnected), separated, spaced apart) from each other. For example, through the trench Tr defined in the pixel defining layer 120, upper functional layers may be spaced apart from each other without being electrically connected to each other.

At this time, the dummy upper functional layer 257 may be formed inside the trench Tr. The dummy upper functional layer 257 may be formed on the dummy emission layer 247. The dummy upper functional layer 257 may include the same material or similar material as the first upper functional layer 251.

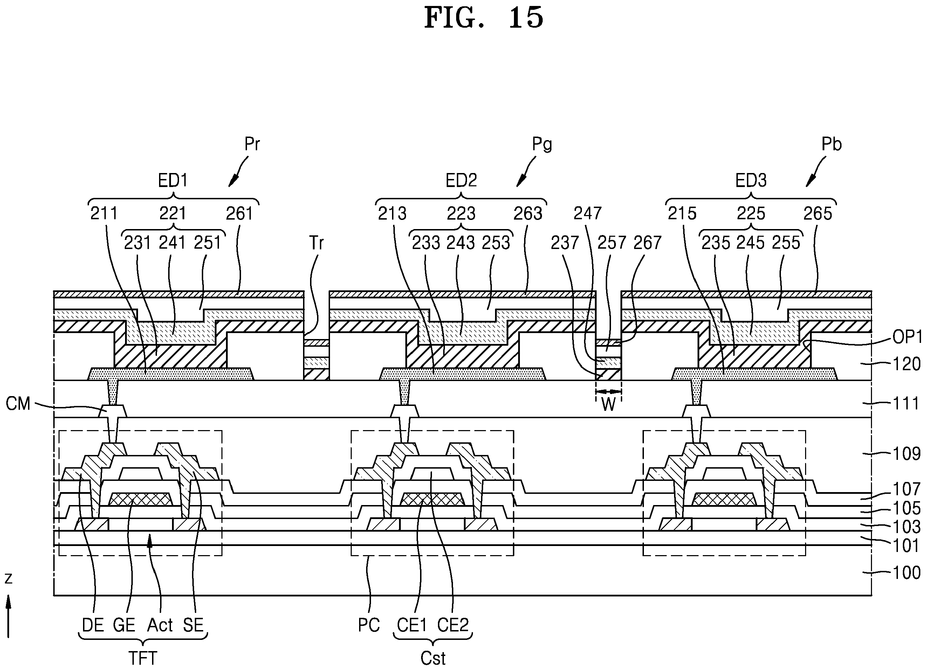

Referring to FIG. 15, the first opposite electrode 261, the second opposite electrode 263, and the third opposite electrode 265 may be respectively formed on the first upper functional layer 251, the second upper functional layer 253, and the third upper functional layer 255. At this time, the first opposite electrode 261, the second opposite electrode 263, and the third opposite electrode 265 may be disconnected (or short-circuited (disconnected), separated, spaced apart) from each other.

The first opposite electrode 261, the second opposite electrode 263, and the third opposite electrode 265 may be deposited without a separate mask. The first opposite electrode 261, the second opposite electrode 263, and the third opposite electrode 265 may be simultaneously formed in the same process. The first opposite electrode 261, the second opposite electrode 263, and the third opposite electrode 265 may include the same material or similar material.

Because the first opposite electrode 261, the second opposite electrode 263, and the third opposite electrode 265 are deposited without a separate mask, in the case that the trench Tr is not formed (or provided) in the pixel defining layer 120, the first opposite electrode 261, the second opposite electrode 263, and the third opposite electrode 265 may be directly connected to (or in contact with) each other.

However, in the disclosure, as the trench Tr is formed (or provided) in the pixel defining layer 120, even in the case that the first opposite electrode 261, the second opposite electrode 263, and the third opposite electrode 265 are deposited without a separate mask, the first opposite electrode 261, the second opposite electrode 263, and the third opposite electrode 265 may be disconnected (or short-circuited (disconnected), separated, spaced apart) from each other. For example, through the trench Tr defined in the pixel defining layer 120, opposite electrodes may be spaced apart from each other without being connected to each other.

At this time, the dummy opposite electrode 267 may be formed in the trench Tr. The dummy upper functional layer 257 may be formed on the dummy opposite electrode 267. The dummy opposite electrode 267 may include the same material or similar material as the first opposite electrode 261.

The first pixel electrode 211, the first lower functional layer 231, the first emission layer 241, the first upper functional layer 251, and the first opposite electrode 261 may form the first light-emitting diode ED1. The second pixel electrode 213, the second lower functional layer 233, the second emission layer 243, the second upper functional layer 253, and the second opposite electrode 263 may form the second light-emitting diode ED2. The third pixel electrode 215, the third lower functional layer 235, the third emission layer 245, the third upper functional layer 255, and the third opposite electrode 265 may form the third light-emitting diode ED3. For example, the first light-emitting diode ED1 may include the first pixel electrode 211, the first lower functional layer 231, the first emission layer 241, the first upper functional layer 251, and the first opposite electrode 261. The second light-emitting diode ED2 may include the second pixel electrode 213, the second lower functional layer 233, the second emission layer 243, and the second upper functional layer 253, and the second opposite electrode 263. The third light-emitting diode ED3 may include the third pixel electrode 215, the third lower functional layer 235, the third emission layer 245, the third upper functional layer 255, and the third opposite electrode 265.

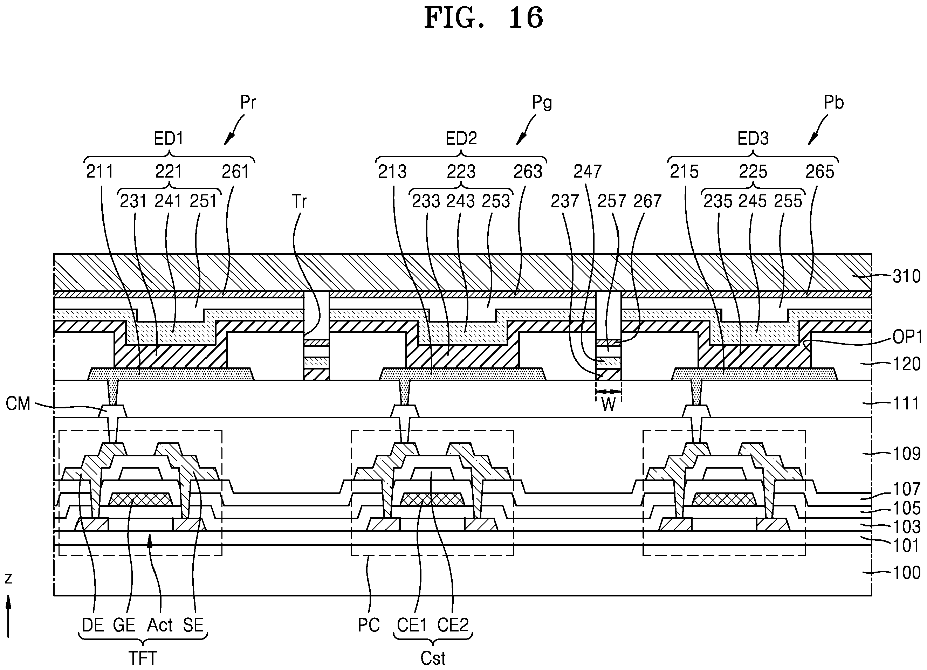

Referring to FIG. 16, the first inorganic encapsulation layer 310 may be formed on the first opposite electrode 261, the second opposite electrode 263, and the third opposite electrode 265. The first inorganic encapsulation layer 310 may be entirely formed on the first opposite electrode 261, the second opposite electrode 263, and the third opposite electrode 265. The first inorganic encapsulation layer 310 may include an inorganic insulating material. At this time, an empty space may be formed between the dummy opposite electrode 267 and the first inorganic encapsulation layer 310. However, the disclosure is not limited thereto. An inorganic insulating material may be provided between the dummy opposite electrode 267 and the first inorganic encapsulation layer 310.

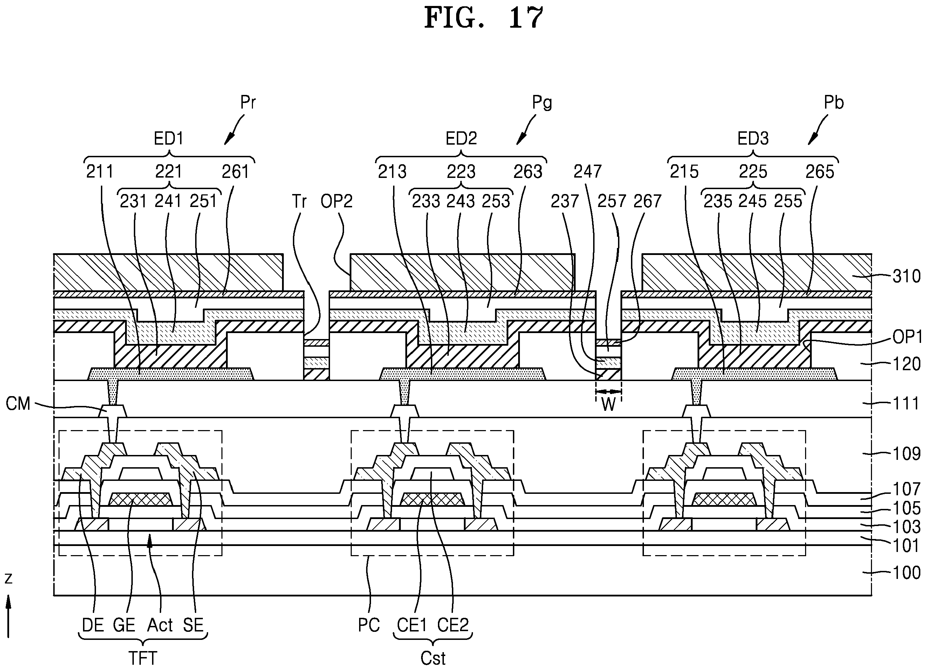

Referring to FIG. 17, the second opening OP2 may be formed (or defined) in the first inorganic encapsulation layer 310. By way of example, after the first inorganic encapsulation layer 310 is formed on the first opposite electrode 261, the second opposite electrode 263, and the third opposite electrode 265, the first inorganic encapsulation layer 310 may be patterned to form the second opening OP2. The second openings OP2 may be formed.

**At** least a portion of each of the first opposite electrode 261, the second opposite electrode 263, and the third opposite electrode 265, which are disposed below the first inorganic encapsulation layer 310, may be exposed through the second opening OP2. For example, at least a portion of each of the opposite electrodes may be exposed through the second opening OP2 defined in the first inorganic encapsulation layer 310.

The second opening OP2 defined in the first inorganic encapsulation layer 310 may overlap at least a portion of the trench Tr defined in the pixel defining layer 120. A width of the second opening OP2 may be greater than the width W of the trench Tr. The second opening OP2 may not overlap an emission area of a pixel. However, the disclosure is not limited thereto.

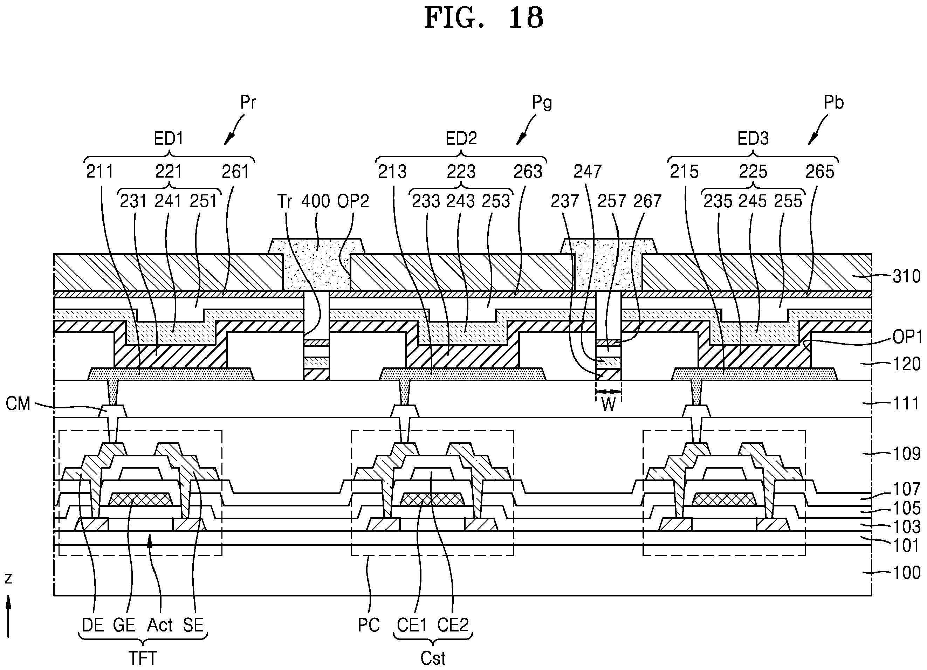

Referring to FIG. 18, the connection electrode 400 may be formed on the first inorganic encapsulation layer 310, the first opposite electrode 261, the second opposite electrode 263, and the third opposite electrode 265. The connection electrode 400 may be formed in the second opening OP2 defined in the first inorganic encapsulation layer 310.

At this time, an empty space may be formed between the dummy opposite electrode 267 and the connection electrode 400. For example, in the case that the connection electrode 400 is deposited, the linearity of a target material may be improved, so that an empty space may be formed between the dummy opposite electrode 267 and the connection electrode 400. For example, in the case that the connection electrode 400 is deposited, the linearity of the target material is improved, so that the connection electrode 400 may not be deposited in the trench Tr.

As described above, in the disclosure, because the trench Tr is formed in the pixel defining layer 120, the first opposite electrode 261, the second opposite electrode 263, and the third opposite electrode 265 may be disconnected (or short-circuited (disconnected), separated, spaced apart) from each other. For example, through the trench Tr defined in the pixel defining layer 120, opposite electrodes may be spaced apart from each other without being connected to each other. However, to drive light-emitting diodes, opposite electrodes need to be electrically connected to each other.

Accordingly, in the disclosure, the opposite electrodes, which are disconnected (or short-circuited (disconnected), separated, spaced apart) from each other, may be electrically connected (or coupled) to each other by using the connection electrode 400. By way of example, the connection electrode 400 may be formed on the first opposite electrode 261 and the second opposite electrode 263, which are at least partially exposed by the second opening OP2, and the first opposite electrode 261 and the second opposite electrode 263, which are spaced apart from each other, may be electrically connected to each other through the connection electrode 400. The connection electrode 400 may be formed on the second opposite electrode 263 and the third opposite electrode 265, which are at least partially exposed by the second opening OP2, and the second opposite electrode 263 and the third opposite electrode 265, which are spaced apart from each other, may be electrically connected to each other through the connection electrode 400. The connection electrode 400 may be formed on the third opposite electrode 265 and the first opposite electrode 261, which are at least partially exposed by the second opening OP2, and the third opposite electrode 265 and the first opposite electrode 261, which are spaced apart from each other, may be electrically connected to each other through the connection electrode 400. Also, although not illustrated in the drawing, the first opposite electrode 261 and the first opposite electrode 261, the second opposite electrode 263 and the second opposite electrode 263, and the third opposite electrode 265 and the third opposite electrode 265 may be electrically connected to each other through the connection electrode 400.

In an embodiment, a thickness of the connection electrode 400 may be greater than a thickness of the first opposite electrode 261 in the thickness direction of the display apparatus. For example, in the thickness direction of the display apparatus, the connection electrode 400 may be provided with a thickness of about 500 angstroms (Å) to about 1000 Å, and the first opposite electrode 261 may be provided with a thickness of about 100 Å to about 150 Å. However, the disclosure is not limited thereto.

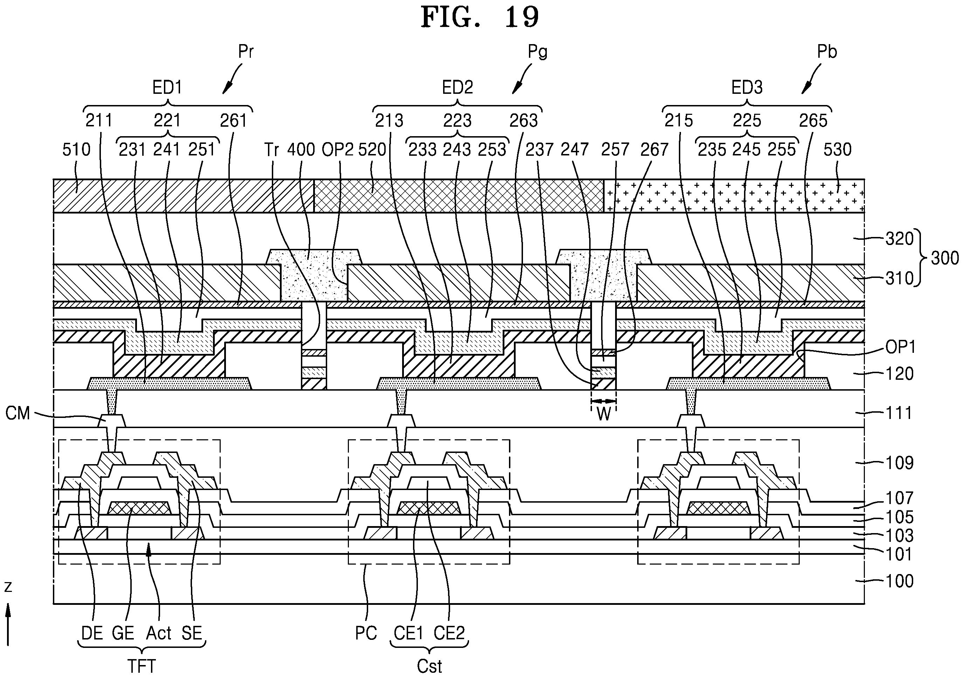

Referring to FIG. 19, the second inorganic encapsulation layer 320 may be formed on the first inorganic encapsulation layer 310 and the connection electrode 400. The second inorganic encapsulation layer 320 may be entirely formed on the first inorganic encapsulation layer 310 and the connection electrode 400. The first inorganic encapsulation layer 310 and the second inorganic encapsulation layer 320 may form the encapsulation layer 300. For example, the encapsulation layer 300 may include the first inorganic encapsulation layer 310 and the second inorganic encapsulation layer 320. FIG. 19 shows that the encapsulation layer 300 may include two inorganic encapsulation layers, but the disclosure is not limited thereto. The encapsulation layer 300 may also include three or more inorganic encapsulation layers.

Also, the first color filter 510, the second color filter 520, and the third color filter 530 may be formed on the encapsulation layer 300. The first color filter 510, the second color filter 520, and the third color filter 530 may respectively overlap the first pixel electrode 211, the second pixel electrode 213, and the third pixel electrode 215. In other words, the first color filter 510, the second color filter 520, and the third color filter 530 may respectively overlap the first emission layer 241, the second emission layer 243, and the third emission layer 245.

As described above, the first color filter 510 may allow light of a first color (for example, red light) to pass through, the second color filter 520 may allow light of a second color (for example, green light) to pass through, and the third color filter 530 may allow light of a third color (for example, blue light) to pass through. Accordingly, because the first color filter 510, the second color filter 520, and the third color filter 530 respectively allow red light, green light, and blue light to pass through, even in the case that white light is emitted from all of the first emission layer 241, the second emission layer 243, and the third emission layer 245, red light, green light, and blue light may be respectively emitted from the first pixel Pr, the second pixel Pg, and the third pixel Pb.

In the display apparatus according to the disclosure, as the trench Tr is formed in the pixel defining layer 120, adjacent intermediate layers are disconnected from each other, opposite electrodes are disconnected from each other, the second opening OP2 is formed in the first inorganic encapsulation layer 310, and the connection electrode 400 is formed in the second opening OP2, and thus the opposite electrodes, which are disconnected from each other, may be electrically connected to each other. By way of example, in the display apparatus according to the disclosure, adjacent emission layers may not be in direct contact with each other by forming the trench Tr in the pixel defining layer 120, and thus the occurrence of mixing color defects may be prevented. In other words, in the display apparatus according to the disclosure, adjacent emission layers are made to be spaced apart from each other by forming the trench Tr in the pixel defining layer 120, and thus the occurrence of mixing color defects may be prevented. Also, the second opening OP2 may be formed in the first inorganic encapsulation layer 310, and the connection electrode 400 may be formed in the second opening OP2, and thus the opposite electrodes, which are spaced apart from each other, may be electrically connected to each other.

According to an embodiment, adjacent emission layers and adjacent opposite electrodes are disconnected from each other by forming a trench in a pixel defining layer, and the adjacent opposite electrodes, which are disconnected from each other, are connected to each other through a connection electrode, and thus the occurrence of mixing color defects may be prevented. However, these effects are examples, and the scope of the disclosure is not limited thereto.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope and as defined by the following claims.

Embodiments are set out in the following clauses:
Clause 1. A display apparatus comprising:
   a first pixel disposed on a substrate and comprising:
      a first pixel electrode;
      a first emission layer disposed on the first pixel electrode; and
      a first opposite electrode disposed on the first emission layer;
   a second pixel disposed on the substrate and comprising:
      a second pixel electrode;
      a second emission layer disposed on the second pixel electrode; and
      a second opposite electrode disposed on the second emission layer;
   a pixel defining layer disposed on the first pixel electrode and the second pixel electrode and including an opening, the opening exposing each of at least a portion of the first pixel electrode and at least a portion of the second pixel electrode;
   a trench included in the pixel defining layer; and
   a connection electrode electrically connecting the first opposite electrode to the second opposite electrode.
Clause 2. The display apparatus of clause 1, wherein a width of the trench is about 5 nm or more and about 200 nm or less.
Clause 3. The display apparatus of clause 1 or clause 2, wherein the first emission layer and the second emission layer are disconnected from each other by the trench.
Clause 4. The display apparatus of any one of clauses 1 to 3, wherein the first opposite electrode and the second opposite electrode are disconnected from each other by the trench.
Clause 5. The display apparatus of any one of clauses 1 to 4, wherein the trench comprises a plurality of trenches.
6. The display apparatus of any one of clauses 1 to 5, further comprising:
   an insulating layer disposed between the substrate and the pixel defining layer,
   wherein the trench is in at least a portion of the insulating layer.
Clause 7. The display apparatus of any one of clauses 1 to 6, further comprising:
   a dummy emission layer and a dummy opposite electrode inside of the trench.
Clause 8. The display apparatus of clause 7, wherein the dummy emission layer and the first emission layer comprise a same material.
Clause 9. The display apparatus of clause 7 or clause 8, wherein the dummy opposite electrode and the first opposite electrode comprise a same material.
Clause 10. The display apparatus of any one of clauses 1 to 9, wherein the first emission layer and the second emission layer emit light of a same color.
Clause 11. The display apparatus of any one of clauses 1 to 9, wherein the first emission layer and the second emission layer emit light of different colors.
Clause 12. The display apparatus of any one of clauses 1 to 11, further comprising:
   an inorganic encapsulation layer disposed on the first opposite electrode and the second opposite electrode,
   wherein a second opening exposing at least a portion of each of the first opposite electrode and the second opposite electrode is defined in the inorganic encapsulation layer.
Clause 13. The display apparatus of clause 12, wherein the connection electrode is disposed in the second opening of the inorganic encapsulation layer.
Clause 14. The display apparatus of clause 12 or clause 13, further comprising:
   a first color filter and a second color filter,
   wherein the first color filter and the second color filter are disposed on the inorganic encapsulation layer.
Clause 15. The display apparatus of clause 14, wherein
   the first color filter at least partially overlaps the first emission layer, and
   the second color filter at least partially overlaps the second emission layer.
Clause 16. The display apparatus of clause 15, wherein light of a first color passes through the first color filter, and light of a second color different from the light of the first color passes through the second color filter.
Clause 17. A method of manufacturing a display apparatus, the method comprising:
   forming a first pixel electrode and a second pixel electrode on a substrate;
   forming a pixel defining layer including a trench on the first pixel electrode and the second pixel electrode; and
   forming the first emission layer and the second emission layer respectively on the first pixel electrode and the second pixel electrode,
   wherein the first emission layer and the second emission layer are disconnected from each other by the trench.
Clause 18. The method of clause 17, wherein a width of the trench is about 5 nm or more and about 200 nm or less.
Clause 19. The method of clause 17 or clause 18, wherein the first emission layer and the second emission layer emit light of a same color.
Clause 20. The method of any one of clauses 17 to 19, wherein the forming of the pixel defining layer including the trench on the first pixel electrode and the second pixel electrode comprises:
   forming the pixel defining layer on the first pixel electrode and the second pixel electrode;
   forming a first opening exposing each of at least a portion of the first pixel electrode and at least a portion of the second pixel electrode in the pixel defining layer; and
   forming the trench in the pixel defining layer.
Clause 21. The method of clause 20, wherein the trench is spaced apart from the first opening.
Clause 22. The method of clause 20 or clause 21, wherein the trench is spaced apart from the first pixel electrode and the second pixel electrode.
Clause 23. The method of any one of clauses 17 to 22, further comprising:
   after the forming of the first emission layer and the second emission layer:
      forming a first opposite electrode and a second opposite electrode respectively
   on the first emission layer and the second emission layer;
      forming an inorganic encapsulation layer including a second opening exposing at least a portion of each of the first opposite electrode and the second opposite electrode on the first opposite electrode and the second opposite electrode; and
      forming a connection electrode electrically connecting the first opposite electrode to the second opposite electrode on the first opposite electrode and the second opposite electrode.
Clause 24. The method of clause 23, wherein the first opposite electrode and the second opposite electrode are disconnected from each other by the trench.
Clause 25. The method of clause 23 or clause 24, further comprising:
   forming a dummy emission layer and a dummy opposite electrode inside of the trench.
Clause 26. The method of clause 25, wherein the dummy emission layer and the first emission layer comprise a same material as the first emission layer.
Clause 27. The method of clause 25 or clause 26, wherein the dummy opposite electrode and the first opposite electrode comprise a same material.
Clause 28. The method of any one of clauses 23 to 27, wherein the forming of the inorganic encapsulation layer including the second opening exposing at least a portion of each of the first opposite electrode and the second opposite electrode on the first opposite electrode and the second opposite electrode comprises:
   forming the inorganic encapsulation layer on the first opposite electrode and the second opposite electrode; and
   forming the second opening in the inorganic encapsulation layer.
Clause 29. The method of clause 28, wherein the second opening at least partially overlaps the trench.
Clause 30. The method of any one of clauses 23 to 29, further comprising:
   forming a first color filter and a second color filter on the inorganic encapsulation layer,
   wherein the first color filter at least partially overlaps the first emission layer, and the second color filter at least partially overlaps the second emission layer.

## Claims

1. A display apparatus comprising:
a first pixel disposed on a substrate and comprising:
a first pixel electrode;
a first emission layer disposed on the first pixel electrode; and
a first opposite electrode disposed on the first emission layer;
a second pixel disposed on the substrate and comprising:
a second pixel electrode;
a second emission layer disposed on the second pixel electrode; and
a second opposite electrode disposed on the second emission layer;
a pixel defining layer disposed on the first pixel electrode and the second pixel electrode and including an opening, the opening exposing each of at least a portion of the first pixel electrode and at least a portion of the second pixel electrode;
a trench included in the pixel defining layer; and
a connection electrode electrically connecting the first opposite electrode to the second opposite electrode.

2. The display apparatus of claim 1, wherein a width of the trench is about 5 nm or more and about 200 nm or less.

3. The display apparatus of claim 1 or claim 2, wherein:
(i) the first emission layer and the second emission layer are disconnected from each other by the trench; and/or
(ii) the first opposite electrode and the second opposite electrode are disconnected from each other by the trench.

4. The display apparatus of any one of claims 1 to 3, wherein:
(i) the trench comprises a plurality of trenches; and/or
(ii) the display apparatus further comprises:
an insulating layer disposed between the substrate and the pixel defining layer,
wherein the trench is in at least a portion of the insulating layer.

5. The display apparatus of any one of claims 1 to 4, further comprising:
a dummy emission layer and a dummy opposite electrode inside of the trench, optionally wherein:
(i) the dummy emission layer and the first emission layer comprise a same material; and/or
(ii) the dummy opposite electrode and the first opposite electrode comprise a same material.

6. The display apparatus of any one of claims 1 to 5, wherein:
(i) the first emission layer and the second emission layer emit light of a same color; or
(ii) the first emission layer and the second emission layer emit light of different colors.

7. The display apparatus of any one of claims 1 to 6, further comprising:
an inorganic encapsulation layer disposed on the first opposite electrode and the second opposite electrode,
wherein a second opening exposing at least a portion of each of the first opposite electrode and the second opposite electrode is defined in the inorganic encapsulation layer.

8. The display apparatus of claim 7, wherein the connection electrode is disposed in the second opening of the inorganic encapsulation layer.

9. The display apparatus of claim 7 or claim 8, further comprising:
a first color filter and a second color filter,
wherein the first color filter and the second color filter are disposed on the inorganic encapsulation layer, optionally wherein
the first color filter at least partially overlaps the first emission layer, and
the second color filter at least partially overlaps the second emission layer, more optionally wherein light of a first color is capable of passing through the first color filter, and light of a second color different from the light of the first color is capable of passing through the second color filter.

10. A method of manufacturing a display apparatus, the method comprising:
forming a first pixel electrode and a second pixel electrode on a substrate;
forming a pixel defining layer including a trench on the first pixel electrode and the second pixel electrode; and
forming the first emission layer and the second emission layer respectively on the first pixel electrode and the second pixel electrode,
wherein the first emission layer and the second emission layer are disconnected from each other by the trench.

11. The method of claim 10, wherein:
(i) a width of the trench is about 5 nm or more and about 200 nm or less; and/or
(ii) the first emission layer and the second emission layer emit light of a same color.

12. The method of claim 10 or claim 11, wherein the forming of the pixel defining layer including the trench on the first pixel electrode and the second pixel electrode comprises:
forming the pixel defining layer on the first pixel electrode and the second pixel electrode;
forming a first opening exposing each of at least a portion of the first pixel electrode and at least a portion of the second pixel electrode in the pixel defining layer; and
forming the trench in the pixel defining layer, optionally wherein:
(i) the trench is spaced apart from the first opening; and/or
(ii) the trench is spaced apart from the first pixel electrode and the second pixel electrode.

13. The method of any one of claims 10 to 12, further comprising:
after the forming of the first emission layer and the second emission layer:
forming a first opposite electrode and a second opposite electrode respectively on the first emission layer and the second emission layer;
forming an inorganic encapsulation layer including a second opening exposing at least a portion of each of the first opposite electrode and the second opposite electrode on the first opposite electrode and the second opposite electrode; and
forming a connection electrode electrically connecting the first opposite electrode to the second opposite electrode on the first opposite electrode and the second opposite electrode.

14. The method of claim 13, wherein:
(i) the first opposite electrode and the second opposite electrode are disconnected from each other by the trench; and/or
(ii) the method further comprises:
forming a dummy emission layer and a dummy opposite electrode inside of the trench, optionally wherein:
(a) the dummy emission layer and the first emission layer comprise a same material; and/or
(b) the dummy opposite electrode and the first opposite electrode comprise a same material.

15. The method of claim 13 or claim 14, wherein:
(i) the forming of the inorganic encapsulation layer including the second opening exposing at least a portion of each of the first opposite electrode and the second opposite electrode on the first opposite electrode and the second opposite electrode comprises:
forming the inorganic encapsulation layer on the first opposite electrode and the second opposite electrode; and
forming the second opening in the inorganic encapsulation layer, optionally wherein the second opening at least partially overlaps the trench; and/or
(ii) the method further comprises:
forming a first color filter and a second color filter on the inorganic encapsulation layer,
wherein the first color filter at least partially overlaps the first emission layer, and the second color filter at least partially overlaps the second emission layer.
